(19) Europäisches Patentamt
European Patent Office
Office européen des brevets

(11) **EP 2 198 523 B1**

(12) **FASCICULE DE BREVET EUROPEEN**

(45) Date de publication et mention
de la délivrance du brevet:
**16.02.2011 Bulletin 2011/07**

(21) Numéro de dépôt: **08834845.3**

(22) Date de dépôt: **02.09.2008**

(51) Int Cl.:
*H03M 13/11* *(2006.01)*

(86) Numéro de dépôt international:
**PCT/FR2008/051558**

(87) Numéro de publication internationale:
**WO 2009/044031 (09.04.2009 Gazette 2009/15)**

(54) **Codage et décodage de codes LDPC non binaires**

Codierung und Decodierung von nichtbinären LDPC Codes

Coding and decoding of non binary LDPC codes

(84) Etats contractants désignés:
**AT BE BG CH CY CZ DE DK EE ES FI FR GB GR HR HU IE IS IT LI LT LU LV MC MT NL NO PL PT RO SE SI SK TR**

(30) Priorité: **10.09.2007 FR 0757457**

(43) Date de publication de la demande:
**23.06.2010 Bulletin 2010/25**

(73) Titulaires:
• **STMicroelectronics SA**
**92120 Montrouge (FR)**
• **Centre National de la Recherche Scientifique - CNRS**
**75016 Paris (FR)**

(72) Inventeurs:
• **VOICILA, Adrian**
**Bucarest (RO)**
• **DECLERCQ, David**
**F-95450 Ableiges (FR)**
• **FOSSORIER, Marc**
**Hawaii 96828 (US)**
• **VERDIER, François**
**F-78230 Le Pecq (FR)**
• **URARD, Pascal**
**F-38570 Theys (FR)**

(74) Mandataire: **Dossmann, Gérard**
**Casalonga & Partners**
**Bayerstrasse 71-73**
**80335 München (DE)**

(56) Documents cités:
• **DAVID DECLERCQ ET AL: "Decoding Algorithms for Nonbinary LDPC Codes Over GF" IEEE TRANSACTIONS ON COMMUNICATIONS, IEEE SERVICE CENTER, PISCATAWAY, NJ, US, vol. 55, no. 4, avril 2007 (2007-04), pages 633-643, XP011177031 ISSN: 0090-6778 cité dans la demande**

**Description**

L'invention concerne les codes du type à contrôle de parité comme par exemple ceux dont les caractéristiques de codes peuvent être représentés notamment par une matrice présentant une faible densité, c'est-à-dire comportant un faible nombre de valeurs non nulles.

De tels codes peuvent être alors considérés comme des codes à faible densité et à contrôle de parité. L'homme du métier connaît des exemples de tels codes sous la dénomination de code « LDPG » (Low Density Parity Check) ».

Les codes LDPC ont été introduits par Gallager en 1962 et redécouverts en 1996 par Mac Kay et Niel. Ces codes jouent un rôle fondamental dans la communication moderne, en particulier en raison de leur très bonne performance de correction d'erreurs.

Actuellement, les codes LDPC généralement utilisés sont des codes LDPC dits binaires c'est-à-dire qu'ils sont définis sur un corps de Galois d'ordre 2. Le mot « corps » doit être compris ici au sens mathématique du terme et on rappelle qu'un corps de Galois est un corps contenant un nombre finis d'éléments.

En d'autres termes, un code LDPC binaire, c'est-à-dire défini sur un corps de Galois d'ordre 2, comporte des symboles capables de prendre uniquement deux valeurs, par exemple les valeurs 0 ou 1.

On connaît par ailleurs d'un point de vue théorique, les codes LDPC dits « non binaires » c'est-à-dire définis sur un corps de Galois d'ordre strictement supérieur à 2, par exemple égal à une puissance entière de 2 strictement supérieure à 1.

Ces codes LDPC non binaires sont intéressants car leur performance en terme de correction d'erreurs peut être significativement augmentée par rapport aux codes LDPC binaires.

En d'autres termes, ces codes LDPC binaires sont plus robustes, notamment avec des jeux de symboles à encoder de petites tailles.

Cela étant, le gain de performance obtenu avec des codes LDPC non binaires s'accompagne d'une augmentation significative de la complexité de décodage ainsi que de la taille mémoire nécessaire pour le décodeur. En effet, par exemple pour un code LDPC défini dans un corps de Galois d'ordre $2^p$, il est nécessaire de stocker des messages de taille $2^p$ et, à l'heure actuelle, ce problème n'a pas été résolu.

Selon un mode de mise en oeuvre et de réalisation, il est proposé un codage de symboles définis sur un corps de Galois d'ordre q strictement supérieur à 2, et un décodage associé, permettant une réalisation d'un décodeur de taille mémoire réduite.

Il est ainsi proposé, selon un mode de mise en oeuvre, de « projeter » les symboles définis dans le corps de Galois d'ordre q, q étant strictement supérieur à 2, en un jeu de symboles équivalents ou sous-symboles, appartenant à des ensembles mathématiques d'ordre inférieur à q. Ces ensembles mathématiques sont dans un exemple particulier des corps mais plus généralement n'importe quelle structure mathématique tels que des groupes ou des anneaux, munis de l'opérateur addition.

Selon un aspect, on élabore un code du type à contrôle de parité défini par des caractéristiques de codes représentables par un graphe comportant des noeuds de contrôle satisfaisant chacun une équation de contrôle de parité. Un graphe d'un code LDPC non binaire classique comporte des noeuds de contrôle et des noeuds de symbole, tous ces noeuds étant définis sur un corps de Galois d'ordre q strictement supérieur à 2 et les noeuds de symbole présentant une première connectivité de liaison vis-à-vis des noeuds de contrôle tandis que les noeuds de contrôle présentent une deuxième connectivité de liaison vis-à-vis des noeuds de symbole. Par rapport à un tel graphe, on subdivise les noeuds de symboles en noeuds de sous-symboles (symboles équivalents) respectivement définis sur des ensembles mathématiques d'ordres inférieurs à q, on remplace les noeuds de symbole par des paquets de noeuds intermédiaires et on relie chaque noeud intermédiaire à un seul noeud de contrôle tout en préservant la connectivité des noeuds de contrôle vis-à-vis des noeuds intermédiaires tandis qu'on relie chaque noeud intermédiaire à plusieurs noeuds de sous-symbole par l'intermédiaire d'un schéma de liaison tout en reportant ladite première connectivité au niveau des noeuds de sous-symbole.

On obtient alors une structure de code totalement nouvelle qui ne peut pas être considérée comme un code LDPC non binaire bien que comme on le verra plus en détails ci-après, le décodeur utilise néanmoins des recombinaisons locales de sous-symboles pour décoder localement dans le corps de Galois d'ordre q mais en mettant à jour les noeuds de sous-symboles dans les ensembles d'ordres inférieurs à q.

Selon un autre aspect, il est proposé à un procédé d'encodage d'un jeu de K symboles initiaux avec un code du type à contrôle de parité.

Les K symboles initiaux appartenant à un corps de Galois d'ordre q strictement supérieur à 2, on définit le code par des caractéristiques de codes représentables par un graphe comportant N-K premiers noeuds, désigné par exemple sous la dénomination de noeuds de contrôle, chaque premier noeud satisfaisant une équation de contrôle de parité définie sur le corps de Galois d'ordre q.

Le graphe comporte par ailleurs N paquets de noeuds intermédiaires et NI deuxièmes noeuds, par exemple également dénommés « noeuds de sous-symbole ».

Chaque noeud intermédiaire est relié à un seul premier noeud et à plusieurs deuxièmes noeuds par l'intermédiaire d'un schéma de liaisons.

On encode le jeu de K symboles initiaux en utilisant lesdites caractéristiques de codes et on obtient un jeu N symboles encodés respectivement subdivisés en NI sous symboles appartenant respectivement à des ensembles mathématiques dont les ordres sont inférieurs à q, selon un schéma de subdivision représentatif du schéma de liaisons.

Bien qu'il soit avantageux, en particulier pour des raisons de simplicité, que chaque symbole soit subdivisé en un même nombre de sous-symboles, il est tout à fait possible que cette subdivision soit irrégulière, c'est-à-dire que le nombre de sous-symboles soit différent d'un symbole à l'autre.

De même, bien qu'il soit avantageux, toujours pour des raisons de simplicité, que les ensembles mathématiques ayant un ordre inférieur à q présentent tous le même ordre, il n'est pas exclu que ces ensembles mathématiques puissent présenter des ordres différents.

A titre d'exemple, lorsque q est égal à $2^p$ avec p strictement supérieur à 1, chaque ordre inférieur à q peut être également une puissance entière de 2, et par exemple égal à $2^{p/ns}$. Dans ce cas, NI est égal au produit de ns par N.

Selon un mode de mise en oeuvre, les N paquets de noeuds intermédiaires sont respectivement associés aux N symboles encodés, et le schéma de subdivision comporte, pour chaque symbole encodé, le nombre et les emplacements des sous-symboles correspondants au sein dudit jeu, ce nombre et ces emplacements étant représentatifs de la partie du schéma de liaison aboutissant au paquet de noeuds intermédiaires associés audit symbole encodé.

Selon un mode de mise en oeuvre, q est égal à $2^p$ avec p strictement supérieur à 1 et chaque ordre inférieur à q est également une puissance entière de 2, et la définition desdites caractéristiques de codes comporte une élaboration d'une première matrice possédant N-K groupes de p lignes respectivement associés aux N-K équations de contrôle de parité et N groupes de p colonnes respectivement associés aux N symboles, chaque groupe de p lignes comportant des blocs de bits de p lignes et de p colonnes formant respectivement des images matricielles binaires des coefficients non nuls de l'équation de contrôle de parité associée audit groupe de p lignes considéré, chacun de ces blocs, associé à un symbole, étant subdivisé en j sous-blocs de bits de p lignes et de $p_i$ colonnes respectivement situés à des emplacements différents sur ledit groupe de p lignes, les valeurs des nombres j et $p_i$ pour i variant de 1 à j ainsi que les positions des différents emplacements des sous-blocs formant un bloc associé à un symbole encodé étant représentatives de partie du schéma de subdivision associée audit symbole encodé ; et on obtient le jeu de symboles encodés à partir de ladite première matrice et du jeu de symboles initiaux.

Ainsi, à titre d'exemple, l'obtention du jeu de symboles encodés peut comporter une diagonalisation de ladite première matrice de façon à obtenir une deuxième matrice (également appelée « matrice génératrice ») et une multiplication de ladite deuxième matrice avec le jeu de symboles initiaux.

En variante, l'obtention du jeu de symboles encodés peut comporter une triangularisation de ladite première matrice de façon à obtenir une deuxième matrice et un calcul récursif des sous-symboles de redondance utilisant ladite deuxième matrice et le jeu de symboles initiaux.

Selon un mode de mise en oeuvre, l'élaboration de ladite première matrice comporte

- une élaboration d'une matrice initiale comportant une première partie représentative des équations de contrôle de parité et une deuxième partie contenant différentes indications de regroupement respectivement représentatives du schéma de subdivision, et
- une détermination de ladite première matrice à partir de ladite matrice initiale.

Cette matrice initiale n'est pas une matrice de parité au sens classique du terme mais permet de décrire complètement la structure de code, et notamment de fournir de façon particulièrement simple, une indication représentative du schéma de subdivision des symboles.

Plus précisément, par exemple, la première partie de la matrice initiale comporte N-K lignes dont les éléments, appartenant au corps de Galois d'ordre q, sont représentatifs des coefficients des différentes équations de contrôle de parité, et la deuxième partie de la matrice initiale comporte NI lignes respectivement associées aux NI deuxièmes noeuds et dont les éléments forment les différentes indications de regroupement, et la première partie et la deuxième partie de la matrice initiale ont le même nombre de colonnes, ce nombre étant égal au nombre de noeuds intermédiaires.

Il est particulièrement avantageux d'élaborer la deuxième partie de la matrice initiale de façon à obtenir pour ladite matrice initiale prise dans sa totalité, un rayon de graphe supérieur ou égal à un seuil désiré.

On rappelle ici qu'un rayon de graphe, selon une dénomination bien connue de l'homme du métier, correspond au cycle minimum du graphe représentant le code. Un cycle représente le chemin le long des liaisons du graphe qui débute d'un noeud quelconque et qui retourne au même noeud.

Le fait d'avoir un rayon de graphe le plus grand possible permet d'améliorer encore les performances du décodage en terme de correction d'erreurs.

Ainsi, on pourra choisir par exemple un seuil désiré égal à 6.

En vue du décodage, il est préférable pour des raisons de simplicité d'implémentation, de fournir également une indication représentative du schéma de subdivision des symboles.

Cela étant une telle indication n'est pas indispensable car il est toujours possible, en utilisant un algorithme approprié, de déterminer au niveau du décodeur toutes les subdivisions possibles utilisées dans le bloc encodé jusqu'à identifier les images binaires des symboles.

Cette indication représentative du schéma de subdivision des symboles peut se présenter sous toute forme appropriée, mais une représentation particulièrement simple en est ladite matrice initiale.

Selon un autre aspect, il est également proposé un dispositif d'encodage comprenant

- une entrée pour recevoir un jeu de K symboles initiaux appartenant à un corps de Galois d'ordre q strictement supérieur à 2,
- des moyens de stockage comportant des caractéristiques de code représentables par un graphe comportant N-K premiers noeuds, chaque premier noeud satisfaisant une équation de contrôle de parité définie sur le corps de Galois d'ordre q, N paquets de noeuds intermédiaires et NI deuxièmes noeuds, chaque noeud intermédiaire étant relié à un seul premier noeud de contrôle et à plusieurs deuxièmes noeuds par l'intermédiaire d'un schéma de liaisons, et
- des moyens d'encodage couplés à l'entrée et aux moyens de stockage et aptes à élaborer un jeu de N symboles encodés respectivement subdivisés en NI sous-symboles appartenant respectivement à ensembles mathématiques dont les ordres sont inférieurs à q, selon un schéma de subdivision représentatif du schéma de liaisons.

Selon un mode de réalisation, dans lequel q est égal à $2^p$ avec p supérieur à 1 et chaque ordre inférieur à q est également une puissance entière de 2, le dispositif comprend en outre des moyens de traitement aptes à élaborer une première matrice également représentative des caractéristiques de code ; cette première matrice possède N-K groupes de p lignes respectivement associés aux N-K équations de contrôle de parité et N groupes de p colonnes respectivement associés aux N symboles, chaque groupe de p lignes comportant des blocs de bits de p lignes et de p colonnes formant respectivement des images matricielles binaires des coefficients non nuls de l'équation de contrôle de parité associée audit groupe de p lignes considéré, chacun de ces blocs, associé à un symbole encodé, étant subdivisé en j sous-blocs de bits de p lignes et de $p_i$ colonnes respectivement situés à des emplacements différents sur ledit groupe de p lignes, les valeurs des nombres j et $p_i$ pour i variant de 1 à j ainsi que les positions des différents emplacements des sous-blocs formant un bloc associé à un symbole encodé étant représentatifs de partie du schéma de subdivision associées audit symbole encodé, et les moyens d'encodage sont aptes à élaborer le jeu de symboles encodés à partir de ladite première matrice.

Selon un mode de réalisation, les moyens de traitement sont en outre aptes

à élaborer une matrice initiale comportant une première partie représentative des équations de contrôle de parité et une deuxième partie contenant différentes indications de regroupement respectivement représentatives du schéma de subdivision, et

à déterminer ladite première matrice à partir de ladite matrice initiale.

Selon un autre aspect, il est également proposé un procédé de décodage d'un jeu de symboles encodés, dans lequel

chaque symbole a été encodé avec un code du type à contrôle de parité défini par des caractéristiques de code représentables par un graphe comportant des premiers noeuds satisfaisant chacun une équation de parité, des deuxièmes noeuds et des noeuds intermédiaires, chaque noeud intermédiaire étant relié à un seul premier noeud et à plusieurs deuxièmes noeuds par un schéma de liaisons ;

chaque symbole encodé du jeu appartient à un corps de Galois d'ordre q strictement supérieur à 2 et est subdivisé en sous-symboles appartenant respectivement à des ensembles mathématiques d'ordres inférieurs à q, selon un schéma de subdivision représentatif du schéma de liaisons et

on effectue une mise à jour itérative des premiers noeuds dans le corps de Galois d'ordre q tandis qu'on effectue une mise à jour itérative des deuxièmes noeuds dans lesdits ensembles mathématiques d'ordres inférieurs à q, en tenant compte dudit schéma de subdivision.

La mise à jour itérative des différents noeuds peut s'effectuer de façon parallèle c'est-à-dire mise à jour itérative de tous les deuxièmes noeuds puis mise à jour de tous les premiers noeuds.

Cela étant, il est plus avantageux d'effectuer une mise à jour séquentielle des premiers noeuds et des noeuds situés dans le voisinage d'un premier noeud mis à jour.

Le procédé comporte également un traitement des noeuds intermédiaires répartis avant et après une mise à jour des premiers noeuds.

Plus précisément, par exemple, le traitement des noeuds intermédiaires comporte un premier sous-traitement de recombinaison effectué avant une mise à jour d'un premier noeud, puis un deuxième sous-traitement ou traitement de marginalisation effectué après la mise à jour du premier noeud.

On peut par exemple effectuer une mise à jour des noeuds en utilisant un algorithme du type à propagation de croyance (algorithme BP : « Belief Propagation » selon une dénomination anglo-saxonne bien connue de l'homme du métier).

Pour le décodage, on peut par exemple stocker sous forme matricielle les caractéristiques de code correspondant au graphe.

Ainsi, ce stockage sous forme matricielle comporte par exemple les différents coefficients des équations de parité ainsi que les informations représentatives du schéma de subdivision des symboles en sous-symboles au sein du jeu.

Selon un autre aspect, il est proposé un dispositif de décodage comprenant

- une entrée pour recevoir un jeu de symboles encodés avec un code du type à contrôle de parité ; chaque symbole encodé du jeu appartient à un corps de Galois d'ordre q strictement supérieur à 2 et étant subdivisé en sous-symboles appartenant respectivement à des ensembles mathématiques d'ordres inférieurs à q, selon un schéma de subdivision,
- des moyens de stockage aptes à stocker des caractéristiques dudit code représentables par un graphe comportant des premiers noeuds satisfaisant chacun une équation de parité, des deuxièmes noeuds et des noeuds intermédiaires, chaque noeud intermédiaire étant relié à un seul premier noeud et à plusieurs deuxièmes noeuds par un schéma de liaisons représentatif su schéma de subdivision,
- des moyens de décodage couplés à ladite entrée et aux moyens de stockage et aptes à effectuer une mise à jour itérative des premiers noeuds dans le corps de Galois d'ordre q et à effectuer une mise à jour itérative des deuxièmes noeuds dans lesdits ensembles mathématiques d'ordres inférieurs à q, en tenant compte dudit schéma de subdivision.

Selon un mode de réalisation, les moyens de décodage sont aptes à effectuer également un traitement des noeuds intermédiaires réparti avant et après une mise à jour des premiers noeuds.

Selon un mode de réalisation, les moyens de décodage sont aptes à mettre à jour de façon séquentielle les différents premiers noeuds et les noeuds situés dans le voisinage de chaque premier noeud mis à jour.

Selon un mode de réalisation, les moyens de décodage sont aptes à mettre en oeuvre un algorithme du type à propagation de croyance.

Selon un mode de réalisation, les moyens de stockage sont aptes à stocker sous forme matricielle les caractéristiques de code correspondant audit graphe.

Selon un mode de réalisation, ladite matrice contient les différents coefficients des équations de parité ainsi que des informations représentatives du schéma de subdivision des symboles en sous-symboles au sein du jeu.

Selon un mode de réalisation, ladite matrice comporte une première partie représentative des équations de contrôle de parité et une deuxième partie contenant différentes indications de regroupement respectivement représentatives des subdivisions des différents symboles encodés.

Selon un mode de réalisation, la première partie de la matrice comporte N-K lignes dont les éléments appartenant au corps de Galois d'ordre q sont représentatifs des coefficients des différentes équations de contrôle de parité, et la deuxième partie de la matrice comporte NI lignes, respectivement associées aux NI deuxièmes noeuds, dont les éléments forment les différentes indications de regroupement ; la première partie et la deuxième partie de la matrice ont le même nombre de colonnes, ce nombre étant égal au nombre de noeuds intermédiaires, et ladite entrée est apte à recevoir un jeu de N symboles encodés et les moyens de décodage sont aptes à délivrer un jeu de K symboles décodés à partir de ladite matrice et du jeu de N symboles.

Selon un autre aspect, il est proposé un appareil de communication couplé à un canal de transmission et comportant un dispositif d'encodage tel que défini ci-avant.

Selon un autre aspect, il est proposé un appareil de communication couplé à un canal de transmission et comportant un dispositif de décodage tel que défini ci-avant.

D'autres avantages et caractéristiques de l'invention apparaîtront à l'examen de la description détaillée de modes de réalisation et de mises en oeuvre, nullement limitatifs, et des dessins annexés sur lesquels :

- la figure 1 illustre de façon schématique un appareil de communication comportant un mode de réalisation d'un dispositif d'encodage et un appareil de communication équipé d'un mode de réalisation d'un dispositif de décodage,
- la figure 2 illustre de façon schématique un mode de mise en oeuvre d'un encodage utilisant un exemple de structure de code subdivisé,
- les figures 3 et 4 illustrent des exemples de graphes relatifs à des structures de codes subdivisés,
- les figures 5 à 12 illustrent de façon schématique des exemples de construction de caractéristiques de codes, notamment sous forme matricielle, concernant une structure de code subdivisé,
- les figures 13 à 15 illustrent des modes de mise en oeuvre d'un décodage d'un code à structure subdivisé, et,
- les figures 16 et 17 illustrent des exemples de performance de décodage utilisant des exemples de structures de codes subdivisés.

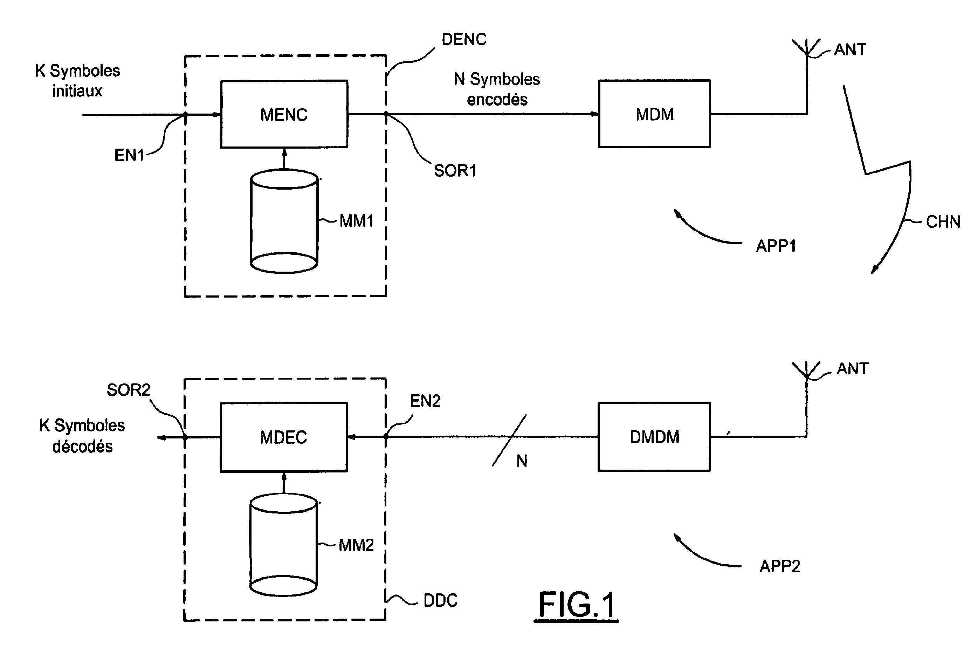

Sur la figure 1, la référence APP1 désigne un appareil de transmission par exemple un appareil sans fil appartenant à un système de communication sans fil bien que l'invention ne soit pas limitée à ce type d'application mais englobe de nombreuses applications comme par exemple les appareils de transmission capables d'échanger des informations via des fibres optiques, ou encore des modems.

D'une façon plus générale, l'invention trouve une application particulièrement avantageuse dans les transmissions à très haut débit ainsi que dans les applications d'enregistrement magnétique comme par exemple les disques durs aux fins de remplacer notamment les codes de type Reed-Solomon actuellement utilisés.

L'appareil APP1 comporte un dispositif d'encodage DENC possédant une entrée EN1 capable de recevoir des jeux successifs de K symboles initiaux de façon à délivrer en sortie SOR1 des jeux successifs de N symboles encodés, qui sont en fait des symboles subdivisés comme on le verra plus en détails ci-après.

Pour effectuer ce codage, le dispositif DENC comporte des moyens d'encodage MENC, couplés entre l'entrée EN 1 et la sortie SOR 1 et utilisant des caractéristiques de codes stockés dans des moyens de stockage MM1, par exemple des moyens de mémoire.

Dans l'exemple décrit ici, la chaîne d'émission de l'appareil APPI comporte également des moyens de modulation aptes à mettre en oeuvre tout type de modulation, par exemple une modulation du type M-PSK ou une modulation du type M-QAM, bien connues de l'homme du métier.

Les informations sont ensuite transmises sur un canal de communication CHN, ici l'air, par l'intermédiaire d'une antenne ANT.

La référence APP2 désigne un appareil de réception comportant une chaîne de réception possédant une antenne ANT.

Des moyens de démodulation DNDM, de structure classique et connue en soi effectuent des traitements de démodulation et délivrent notamment N informations qui sont en fait des informations de probabilité. Par ailleurs, comme on le verra plus en détails ci-après, chaque information est en fait un vecteur.

Ces N informations, qui correspondent en fait aux N symboles encodés ayant été transmis, sont délivrés à l'entrée EN2 d'un dispositif de décodage DDC.

Ce dispositif de décodage DDC comporte des moyens de décodage MDEC utilisant les mêmes caractéristiques de codes que celles utilisées pour le codage. Ces caractéristiques de code sont également stockées dans des moyens de stockage MM2, par exemple du type mémoire.

La sortie SOR2 des moyens de décodage fournit une estimation des K symboles décodés.

Chaque symbole de chaque jeu de K symboles initiaux est un symbole défini sur un corps de Galois d'ordre q, dénommé GF(q) (« Galois Field » selon une dénomination anglo-saxonne habituellement utilisée par l'homme du métier) avec q strictement supérieur à 2.

De ce fait, chaque symbole initial est susceptible de prendre q valeurs.

Dans la suite du texte, et bien que l'invention n'y soit pas limitée, on considèrera que q est égal à $2^p$ avec p strictement supérieur à 1.

Dans ce cas, chaque symbole peut être représenté par un ensemble de p bits, chacun de ces bits pouvant prendre les valeurs 0 ou 1.

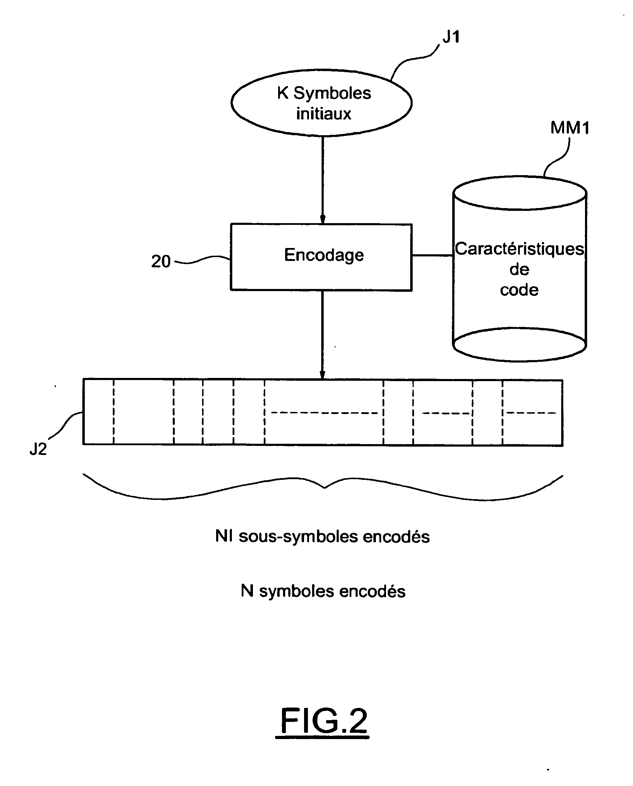

Comme illustré sur la figure 2, un jeu J1 de K symboles initiaux est encodé (étape 20) en utilisant les caractéristiques de codes contenues dans la mémoire MM1 et un jeu J2 de N symboles encodés est délivré. Chacun de ces N symboles encodés est également défini sur le corps de Galois GF(q) mais est subdivisé en sous-symboles, et de ce fait ce jeu J2 se compose de NI sous-symboles encodés.

Chacun des sous-symboles est défini sur un ensemble mathématique qui, dans l'exemple décrit ici est également un corps, ayant un ordre inférieur à q.

Par ailleurs, le nombre de sous-symboles formant un symbole encodé peut être différent ou identique pour chaque symbole.

De même, la taille des sous-symboles peut être différente selon les symboles.

Cela étant, pour des raisons de simplification, on supposera maintenant que les sous-symboles encodés sont tous définis sur le même ensemble mathématique, par exemple un corps, ayant un même ordre inférieur à q.

Plus particulièrement, on supposera dans ce qui suit que chaque symbole encodé est subdivisé en ns sous-symboles. De ce fait, chaque sous-symbole est par conséquent défini sur le corps de Galois GF ($2^{p/ns}$).

En d'autres termes, le jeu J2 de N symboles encodés comporte en fait NI sous-symboles encodés, NI étant égal au produit de ns par N.

Une telle structure de code sera dénommée par la suite « structure de code à symbole subdivisé » ou, plus simplement « structure de code subdivisé ».

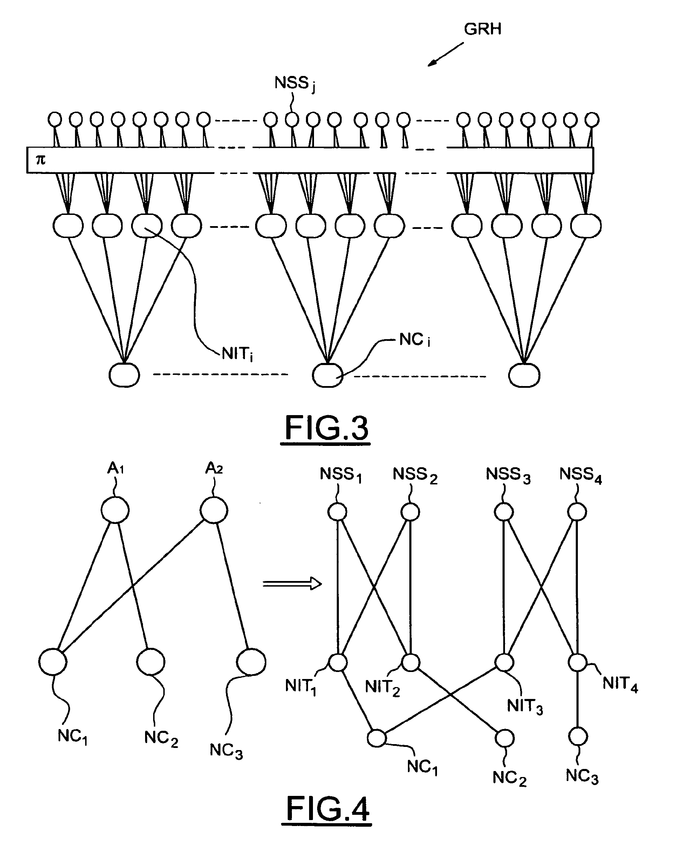

Si l'on se réfère maintenant plus particulièrement à la figure 3, pour laquelle ns = 4, on voit qu'une telle structure de code subdivisé présente des caractéristiques de codes qui peuvent être représentés par un graphe GRH comportant M = N-K premiers noeuds $NC_i$ encore dénommé « noeud de contrôle » ou « Check Node » selon une dénomination anglo-saxonne couramment utilisée par l'homme du métier.

Chacun de ces premiers noeuds satisfait une équation de contrôle de parité qui est définie sur le corps de Galois d'ordre q et sur laquelle on reviendra plus en détails ci-après.

Le graphe GRH comporte également NI deuxièmes noeuds encore appelés « noeuds de sous-symbole », $NSS_j$.

Par ailleurs, le graphe comporte N paquets de noeuds intermédiaires $NIT_i$, les N paquets de noeuds intermédiaires étant respectivement associés aux N symboles encodés.

Chaque noeud intermédiaire est relié à un seul noeud de contrôle et à plusieurs noeuds de sous-symboles par l'intermédiaire d'un schéma de liaisons référencé ici n.

En fait, le jeu J2 de N symboles encodés est subdivisé en NI symboles selon un schéma de subdivision qui est représentatif du schéma de liaison $\Pi$.

Et, le schéma de subdivision comporte, pour chaque symbole encodé, le nombre et les emplacements des sous-symboles correspondants au sein du J2, ce nombre et ces emplacements étant représentatifs de la partie du schéma de liaison aboutissant au paquet de noeuds intermédiaires associé au symbole encodé.

La partie gauche de la figure 4 représente une partie d'un graphe d'un code LDPC non binaire classique sur GF(q) comportant des noeuds de contrôle (ici 3) $NC_1$-$NC_3$ et deux noeuds de symboles $A_1$ et $A_2$ définis sur GF(q).

On voit sur cette partie de graphe que chaque noeud de symbole $A_1$ et $A_2$ présente une connectivité de degré 2 vis-à-vis des noeuds de contrôle.

Une caractéristique de l'invention, qui consiste à « projeter » ou transformer des noeuds de symbole en noeuds de sous-symbole définis sur un corps de Galois d'ordre inférieur à q, se traduit par une modification du graphe telle que par exemple celle illustrée sur la partie droite de la figure 4.

On voit sur cette partie droite que les noeuds de symbole sont supprimés et, si l'on suppose que chaque symbole est subdivisé en deux sous-symboles, on obtient effectivement quatre noeuds de sous-symboles $NS_1$-$NS_4$.

Le noeud de symbole $A_1$ est subdivisé en les noeuds de sous-symboles $NSS_1$ et $NSS_2$ tandis que le noeud de symbole $A_2$ est subdivisé en noeuds de sous-symboles $NSS_3$ et $NSS_4$.

En ce qui concerne les noeuds intermédiaires, ils sont reliés chacun à un seul noeud de contrôle. Par contre, comme le symbole $A_1$ est relié aux noeuds de contrôle $NC_1$ et $NC_2$, il faut lui associer les deux noeuds intermédiaires $NIT_1$ et $NIT_2$ qui seront respectivement connectés aux noeuds de contrôle $NC_1$ et $NC_2$.

De même, puisque le symbole $A_2$ est connecté aux deux noeuds de contrôle $NC_1$ et $NC_3$, et que chaque noeud intermédiaire ne peut être connecté qu'à un seul de contrôle, il faut associer au noeud de symbole $A_2$ les deux noeuds intermédiaires $NIT_3$ et $NIT_4$ qui seront respectivement connectés aux noeuds de contrôle $NC_1$ et $NC_3$.

Par contre, on reporte la connectivité des noeuds de symbole au niveau des noeuds de sous-symboles comme illustré sur la partie droite de la figure 4.

Les caractéristiques de codes, qui sont représentables par un graphe, peuvent être également représentées sous forme matricielle.

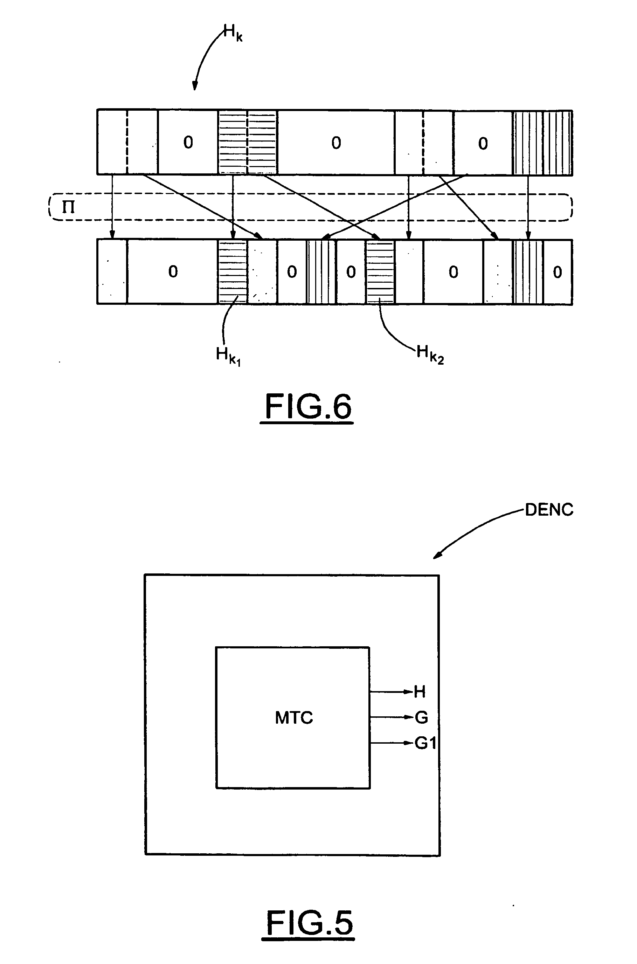

A cet égard, comme illustré sur la figure 5, il est prévu que le dispositif d'encodage DENC comporte des moyens de traitement NTC capables d'élaborer une matrice H par exemple, à partir de laquelle va pouvoir être déterminé chaque jeu J2 de symboles encodés.

On sait que pour un code LDPC non binaire défini sur GF(q) avec $q = 2^p$, chaque coefficient non nul d'une équation de contrôle de parité peut être représenté sous la forme d'un bloc de bits de p lignes et de p colonnes formant ainsi l'image matricielle binaire de ce coefficient. L'homme du métier pourra se référer à toutes fins utiles à l'Article de C. Poulliat, M. Fossorier and D. Declercq, « Design of non binary LDPC codes using their binary image : algebraic properties », in the proc. of ISIT'06, Seattle, USA, July 2006.Et, chaque bloc matriciel de p x p bits, référencé $H_k$ (figure 6) est associé à un symbole.

La subdivision des symboles en sous-symboles se traduit, comme illustré sur la figure 6, en une subdivision du bloc $H_k$ en j sous-blocs (ici j est égal à deux car chaque symbole est supposé être subdivisé en deux sous-symboles). Chaque sous-bloc de bits comporte p lignes et un nombre $p_i$ de colonnes égal à la taille du sous-symbole (i = 1, ...j).

Dans le cas présent, puisque l'on suppose que tous les symboles sont subdivisés en deux sous-symboles, le nombre $p_i$ de colonnes de chaque sous-bloc est identique.

Par contre, les positions des différents emplacements des sous-blocs formant un bloc associé à un symbole encodé sont représentatifs de la partie du schéma de subdivision associé audit symbole encodé.

Dans l'exemple de la figure 6, le bloc $H_k$ est subdivisé en deux sous-blocs $H_{k1}$, et $H_{k2}$.

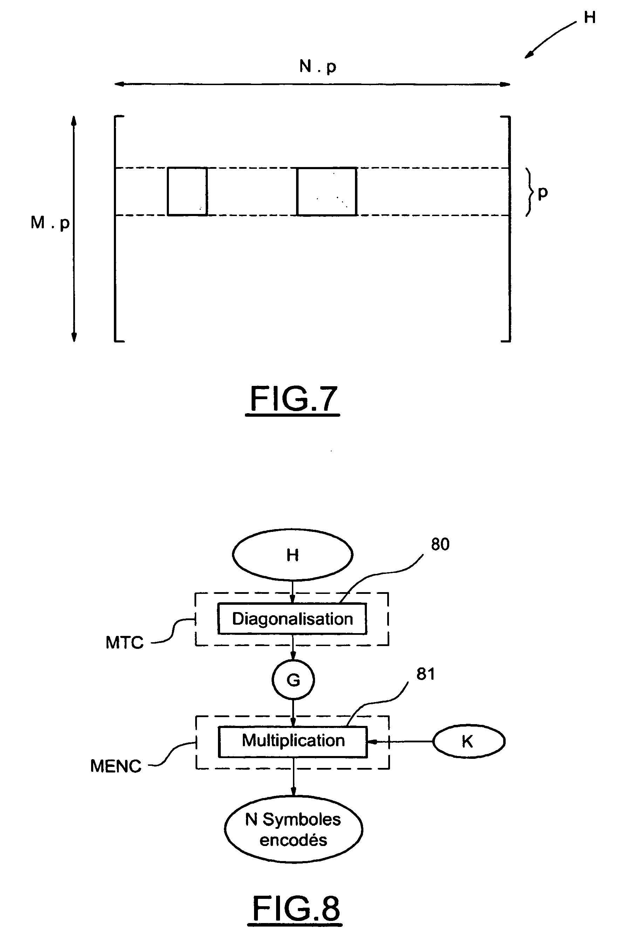

Ainsi, comme illustré sur la figure 7, cette matrice H, également dénommée « première matrice », comporte M groupes de p lignes respectivement associées au M équations de contrôle de parité (M est égal à N-K) et N groupes de p colonnes respectivement associées au N symboles encodés.

Chaque groupe de p lignes comporte les blocs de bits de p lignes et de p colonnes formant les images matricielles binaires des coefficients non nuls de l'équation de contrôle de parité associés auxdits groupes de p lignes considérés.

Et, chacun de ces blocs est subdivisé en j sous-blocs comme indiqué ci-avant, les valeurs des nombres j ainsi que les valeurs $P_i$ (i = 1 à j) du nombre des colonnes des sous-blocs et les positions des différents emplacements des sous-blocs formant un bloc associé à un symbole encodé sont représentatifs de la partie du schéma de subdivision associé à ce symbole encodé.

Ainsi, alors qu'une équation de contrôle de parité de degré $d_{c-1}$ dans un code LDPC non binaire classique GF (q) est définie par la formule ci-dessous :

$$\sum_{k=0}^{d_c-1} h_k \, A_k = 0$$

dans laquelle $A_k$ désigne un symbole dans GF(q) et $h_k$ désigne un coefficient non nul de l'équation de contrôle de parité (également dans GF (q),

cette équation de contrôle de parité peut être écrite dans le cas d'une structure de code subdivisé sous la forme matricielle par la formule ci-dessous :

$$\sum_{k=0}^{d_c-1} \sum_{i=1}^{n_s} H_{k_i} SS_{k_i} = 0$$

dans laquelle $SS_{k_i}$ désigne un sous-symbole, et ns le nombre de sous-symboles (supposé ici constant et identique) formant un symbole.

En fait, quelle que soit la façon dont on subdivise les symboles en sous-symboles, c'est-à-dire quels que soient les emplacements des différents sous-blocs au sein des différents groupes de p lignes, on obtiendra toujours une structure de code du type subdivisé qui va permettre d'obtenir des symboles encodés sur des corps de Galois d'ordre inférieur à q et qui va permettre de ce fait, lors du décodage, de réduire la taille mémoire nécessaire au décodage puisque la taille des sous-symboles qui devront être stockés aura été réduite.

Cela étant, comme on le verra plus en détails ci-après, un schéma de subdivision approprié, conduisant à des emplacements appropriés des sous-blocs au sein de la matrice H, va permettre d'améliorer la performance du codage et du décodage, en terme de correction d'erreurs notamment.

A partir de la matrice H, les moyens de traitement MTC peuvent effectuer par exemple un traitement de diagonalisation 80 (figure 8), bien connu de l'homme du métier, afin d'obtenir une matrice G dite matrice génératrice qui va permettre l'élaboration des symboles encodés.

En effet, les moyens d'encodage MENC vont élaborer le jeu J2 de N symboles encodés (figure 8) en multipliant (étape 81) le jeu de K symboles initiaux avec la matrice génératrice G.

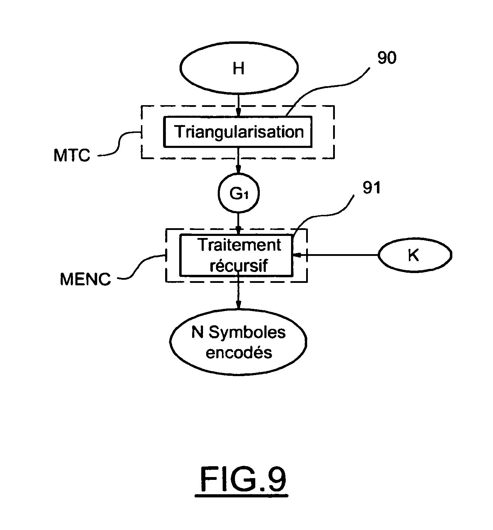

Une autre solution illustrée sur la figure 9, consiste à effectuer un traitement de triangularisation (étape 90, figure 9) de la matrice H de façon à obtenir une matrice G1 puis d'effectuer, de façon classique et connue en soi, un calcul récursif (étape 91) des sous-symboles de redondance en utilisant la matrice G1 et le jeu de K symboles initiaux, pour obtenir les N symboles encodés.

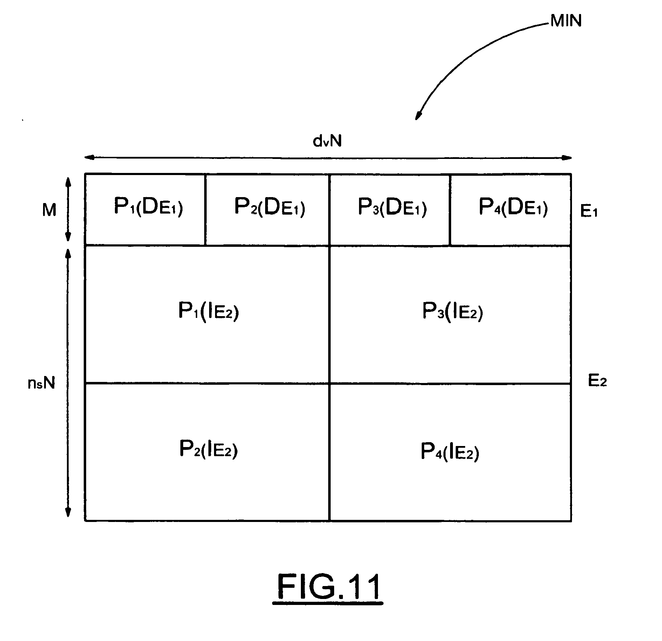

Une autre façon de représenter les caractéristiques de code consiste à élaborer une matrice dite initiale, MIN telle que celle illustrée sur la figure 11 dans un cas particulier. Une telle matrice initiale MIN comporte comme on va le voir ci-après, une première partie représentative des équations de contrôle de parité et une deuxième partie contenant différentes indications de regroupement respectivement représentatives du schéma de subdivision.

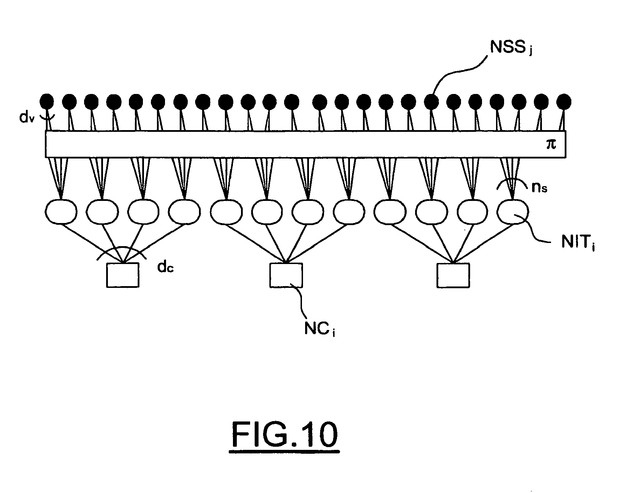

Pour décrire plus précisément la structure de la matrice MIN illustrée sur la figure 11, on suppose que l'on est en présence d'un graphe de code à structure subdivisée du type de celui de la figure 10.

On voit sur cette figure 10 que l'on a un degré de connexion des noeuds de contrôle égal à $d_c$ et un degré de connexion des noeuds de sous-symboles $NSS_j$ égal à $d_v$.

Par ailleurs, on suppose que chaque symbole encodé est subdivisé en $n_s$ symboles équivalents ou sous-symboles.

Par ailleurs, on considère dans cet exemple que $d_v$ est égal à $n_s$ et (ces deux valeurs étant égales à 2) et que de est égal à 4.

La première partie E1 de la matrice initiale MIN comporte M = N-K lignes dont les éléments, appartenant au corps de Galois d'ordre $2^p$, sont représentatifs des coefficients des différentes équations de contrôle de parité.

En d'autres termes, la première partie E1 de la matrice MIN correspond au profil des noeuds de contrôle.

La deuxième partie E2 de la matrice MIN comporte un nombre de lignes égal au nombre de sous-symboles, en l'espèce N fois ns.

Chacune des lignes est associée à un sous-symbole et les éléments de la deuxième partie E2 de la matrice MIN forment les différentes indications de regroupement.

Par ailleurs, la matrice MIN possède un nombre de colonnes égal au nombre de noeuds intermédiaires, en l'espèce $Nd_v$.

Comme indiqué ci-avant, les éléments de la deuxième partie E2 de la matrice MIN forment les différents indications de regroupement permettant de former les symboles à partir des sous-symboles. A cet égard, une valeur logique égale à 1 par exemple à l'intersection d'une ligne et d'une colonne de deuxième partie E2 de la matrice MIN, signifie que le sous-symbole correspondant est relié au noeud intermédiaire correspondant.

La connexion des noeuds intermédiaires aux noeuds de contrôle est quant à elle définie par la première partie E1 de la matrice MIN.

Par ailleurs, sur la figure 11, $D_{E_1}$ désigne la matrice diagonale de taille MxM.

$I_{E_2}$ désigne la matrice d'identité de taille NxN.

$P_i$ désigne une permutation circulaire.

On voit donc que les matrices E1 et E2 sont construites en utilisant une construction basée sur une permutation circulaire. En d'autres termes, $P_i(I_{E_2})$ pour i = 1 à 4, est une matrice résultant d'une permutation circulaire de la matrice $I_{E_2}$.

Il convient de noter ici que cette matrice MIN n'est pas une matrice de parité au sens classique du terme mais permet de décrire complètement la structure de code subdivisée.

L'avantage d'une telle construction d'une matrice initiale réside d'une part dans la simplicité de la construction mais également dans l'obtention de bonnes propriétés du rayon de graphe.

On rappelle ici que le rayon de graphe est le chemin minimum au sein du graphe partant d'un symbole quelconque pour retourner à ce même symbole.

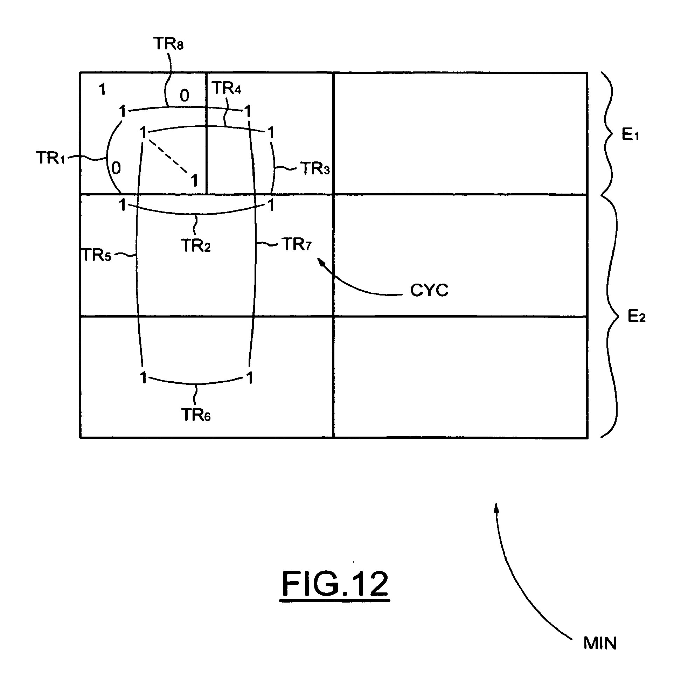

Et, en choisissant de placer de façon appropriée les éléments non nuls de la deuxième partie E2 de la matrice initiale MIN (figure 12) on peut obtenir des cycles dont la valeur minimum est supérieure à un seuil désiré.

A titre d'exemple, comme illustré sur la figure 12, le cycle CYC partant du noeud intermédiaire situé sur la deuxième colonne et la deuxième ligne de la matrice E1 et aboutissant à ce même noeud est effectué en huit trajets TR1-TR8.

L'homme du métier saura déterminer le seuil souhaitable pour le rayon de graphe en fonction de l'application envisagée et des performances souhaitées pour le décodage.

Cela étant, un seuil supérieur ou égal à 6 est une valeur acceptable.

Il convient de noter ici que la structure de code subdivisé qui vient d'être décrite est une famille totalement nouvelle de code qui ne peut pas être assimilée à un code LDPC non binaire. En effet, cette structure de code ne définit pas une fonction de codage linéaire sur GF(q), autrement dit, il n'existe pas de matrice de parité H ou génératrice G prenant ses éléments dans GF(q), et définissant le code. Un code à symboles subdivisés reste cependant un code de parité au sens usuel sur GF(2), ayant une image de matrice de parité binaire comme précisé plus haut.

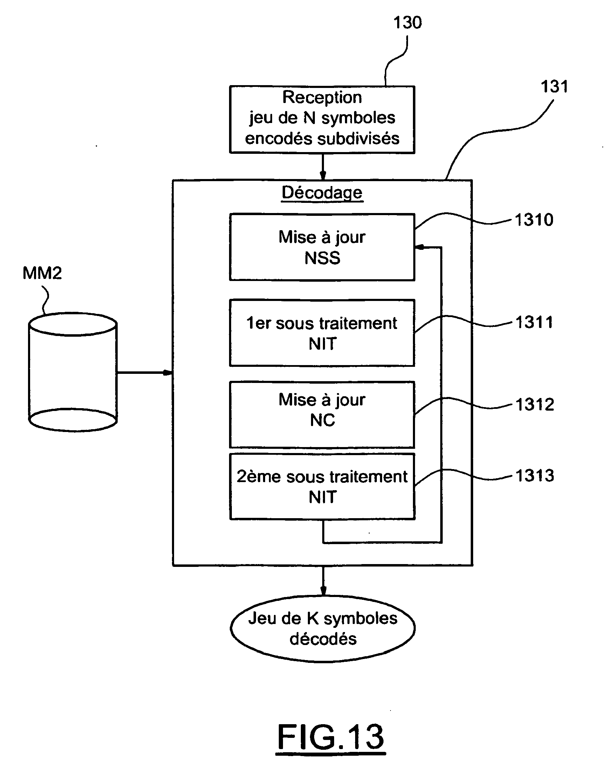

On se réfère maintenant de nouveau à la figure 1 mais également aux figures 13 à 15 pour illustrer un mode de mise en oeuvre du décodage de blocs encodés avec une structure de code du type subdivisé.

On suppose également toujours à des fins de simplification que q est égal à $2^p$, chaque symbole encodé pouvant donc être représenté sous la forme d'un vecteur de p bits, et que chaque symbole est subdivisé en ns sous-symboles.

Si l'on se réfère à la figure 1, en sortie des moyens de démodulation DMDM, on obtient donc un jeu de N informations correspondant aux N symboles encodés qui ont été émis sur le canal de transmission.

Cela étant, compte tenu des conditions réelles de transmission, chaque information est un vecteur de p données qui sont en fait des valeurs de probabilité communément désignées par l'homme du métier sous la dénomination anglo-saxonne de LLR : « Log Likelihood Ratio ». En fait, le signe de la donnée indique la valeur logique du bit associé et la valeur absolue de la donnée indique le degré de confiance dans ladite valeur logique.

Ainsi, la sortie des moyens de démodulation DMDM délivre N vecteurs de LLRs représentant les N symboles encodés. Cela étant, à des fins de simplification et par abus de langage, on désignera dans la suite du texte les N vecteurs de LLR par l'expression « N symboles encodés ».

Bien entendu, ces N symboles encodés sont en fait subdivisés en NI sous-symboles qui vont être décodés par les moyens de décodage.

D'une façon générale, comme illustré sur la figure 13, après réception du jeu de N symboles encodés subdivisés (étape 130) on procède au décodage 131.

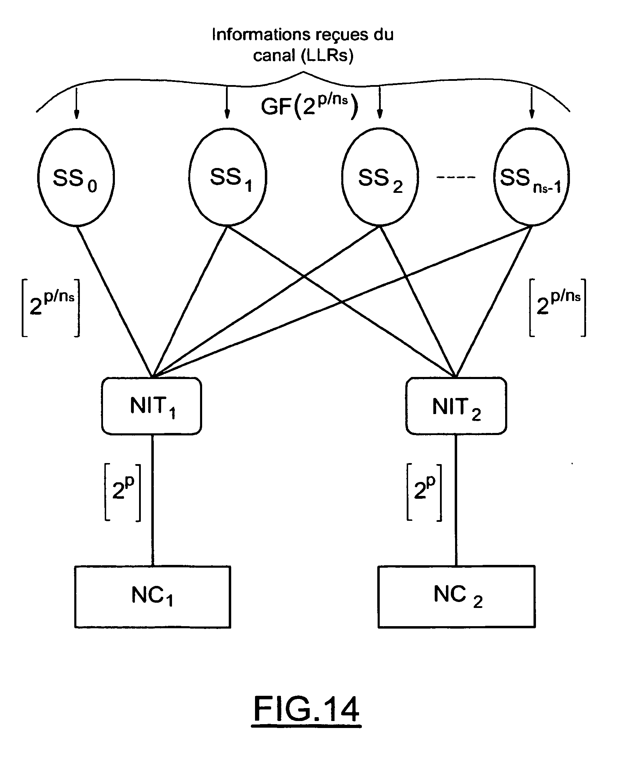

Ce décodage comprend tout d'abord une initialisation des noeuds de sous-symboles avec les valeurs des informations (LLRs) reçues du canal (figure 14 ; sur cette figure ns = 4).

A cet égard, le décodeur interprète les $p/n_s$ bits reçus du canal comme un seul symbole (en fait un sous-symbole) défini sur le corps de Galois GF $(2^{p/ns})$.

Le décodage comporte l'échange itératif de messages entre ces différents noeuds, ces messages étant des vecteurs de LLRs.

Les noeuds de sous-symboles NSS sont mis à jour (étape 1310, figure 13). A cet égard, la taille des messages qui doivent être stockés est réduite puisque cette mise à jour est effectuée dans le corps de Galois d'ordre $2^{p/ns}$.

Le décodage comporte également une mise à jour des noeuds de contrôle (étape 1312) effectuée dans le corps de Galois d'ordre q, ainsi qu'un traitement des noeuds intermédiaires (étapes 1311 et 1313) qui est réparti avant et après la mise à jour des noeuds de contrôle.

En fait, comme on le verra plus en détails ci-après, un premier sous-traitement des noeuds intermédiaires consiste en une recombinaison de probabilités et un deuxième sous-traitement consiste en un traitement de marginalisation.

Ce décodage est itératif comme le montre la flèche référencée 1314 sur la figure 13.

Au bout d'un certain nombre d'itérations et/ou la satisfaction d'un critère d'arrêt de décodage, on obtient K vecteurs de LLRs dont les signes vont fournir les valeurs logiques des K ensembles de p bits correspondant aux K symboles décodés.

Pour effectuer ce décodage, on peut utiliser un algorithme du type à propagation de croyance, bien connu de l'homme du métier sous la dénomination anglo-saxonne de BP : «Belief propagation ».

Une solution pour effectuer ce décodage itératif peut consister à mettre à jour d'abord tous les noeuds de sous-symboles, puis à effectuer le premier sous-traitement de tous les noeuds intermédiaires, puis à effectuer une mise à jour de tous les noeuds de contrôle et enfin effectuer le traitement de marginalisation pour tous les noeuds intermédiaires.

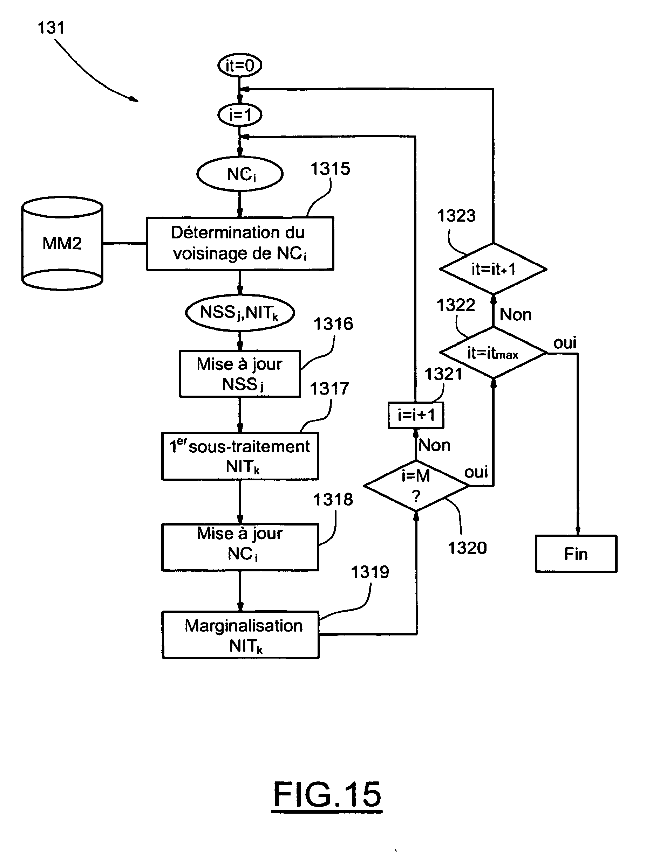

Cela étant, une solution plus efficace consiste à effectuer une mise à jour séquentielle des noeuds dont un exemple de mise en oeuvre est illustré sur la figure 15.

Sur la figure 15, it désigne le nombre d'itérations et i l'indice d'un noeud de contrôle NC.

Pour un noeud courant $NC_i$ on détermine (étape 1315) le voisinage du noeud $NC_i$, c'est-à-dire les noeuds de sous-symboles $NSS_j$ et $NIT_k$ qui sont reliés à ce noeud de contrôle.

Cette détermination du voisinage est obtenue ici à partir d'une indication représentative du schéma de subdivision des symboles, bien que, comme cela a déjà été évoqué ci-avant, une telle indication n'est pas en soi absolument indispensable mais facilite le décodage.

En l'espèce, cette indication résulte par exemple de la matrice initiale MIN contenue dans la mémoire MM2.

Après avoir déterminé les noeuds de sous-symboles $NSS_j$ connectés à ce noeud de contrôle $NC_i$, on effectue une mise à jour (étape 1316) de ces noeuds de sous-symboles. Cette mise à jour est comme indiqué ci-avant effectuée dans le corps de Galois d'ordre $2^{p/ns}$.

Les équations de mises à jour de tels noeuds dans un corps de Galois sont bien connus de l'homme du métier et celui-ci pourra par exemple se référer à toutes fins utiles à l'article de David Declercq et Marc Fossorier intitulé « Decoding Algorithmes for Nonbinary LDPC Codes over GF (q) », IEEE Trans. On Commun., vol 55(4), pp. 633-643, April 2007.On rappelle ici que la mise à jour consiste à prendre en compte, en particulier par une opération d'addition, les messages aboutissant aux noeuds de sous-symboles considérés excepté celui provenant du noeud de contrôle auquel est relié indirectement ce sous-symbo le.

On effectue ensuite le premier sous-traitement 1317 des noeuds intermédiaires $NIT_k$ connectés à ces noeuds de sous-symboles mis à jour.

Ce premier sous-traitement est un traitement de recombinaison de probabilités.

Ainsi, la probabilité que la valeur du noeud intermédiaire NIT soit égale à $\alpha_i$ est obtenue à partir des valeurs $\beta$ des noeuds de sous-symboles en utilisant les règles de probabilités conditionnelles de Bayes conformément à la formule ci-dessous :

$$P(NIT = \alpha_i) = P(SS_0 = \beta_0, ..., SS_{x-1} = \beta_{x-1})$$
$$P(SS_0 = \beta_0 | SS_1 = \beta_1, ..., SS_{x-1} = \beta_{x-1}) P(SS_1 = \beta_1 | SS_2 = \beta_2, ..., SS_{x-1} = \beta_{x-1}) ... P(SS_{x-1} = \beta_{x-1})$$

Cela étant, pour simplifier cette équation, on peut utiliser une hypothèse d'indépendance entre les sous-symboles pour obtenir une expression plus simple définie par la formule ci-dessous :

$$P(NIT = \alpha_i) = P(SS_0 = \beta_0) P(SS_1 = \beta_1) ... P(SS_{x-1} = \beta_{x-1})$$

On effectue ensuite une mise à jour du noeud de contrôle $NC_i$ (étape 1318). Cette mise à jour est effectuée dans le corps de Galois d'ordre q et est une mise à jour classique en soi et bien connue de l'homme du métier. Ce dernier pourra également se référer à l'Article de David Declercq mentionné ci-dessus.

Enfin, on effectue un deuxième sous-traitement 1319 des noeuds intermédiaires $NIT_k$ qui est un traitement de marginalisation conformément par exemple à l'équation à la formule ci-dessous :

$$P(SS_i = \beta_i) = \sum_{SS_0=0}^{GF(2^{p/ns})-1} \cdots \sum_{SSj=0, j\neq i}^{GF(2^{p/ns})-1} \cdots \sum_{SS_{ns-1}=0}^{GF(2^{p/ns})-1} P(A|S_i = \beta_i, SS_0,...,SS_j,...SS_{ns-1})$$

$$\times P(SS_0 = \beta_0)...P(SS_j = \beta_j)...P(SS_{ns-1} = \beta_{ns-1})$$

pour laquelle on a toujours supposé l'indépendance mutuelle des sous-symboles.

Puis, on passe au noeud de contrôle suivant et on réitère les opérations qui viennent d'être décrites.

Lorsque i est égal à M, c'est-à-dire lorsque tous les noeuds de contrôle ont été traités, on incrémente le compteur d'itérations (étape 1323) et l'on répète les étapes qui viennent d'être décrites.

Lorsque le nombre d'itérations est égal au nombre d'itérations maximum prédéfinies ITmax (étape 1322), on met fin à l'algorithme de décodage. Bien entendu ce critère d'arrêt n'est qu'un exemple, et tout autre critère d'arrêt classique convient.

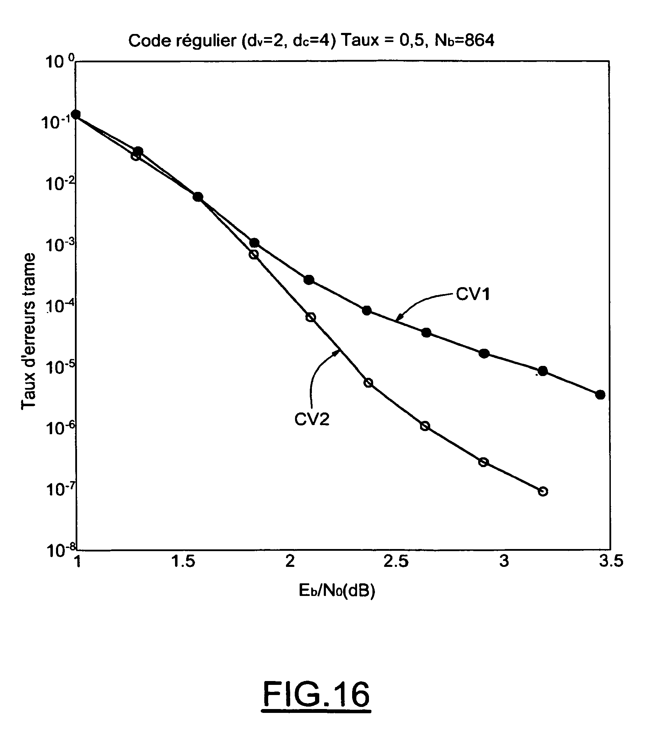

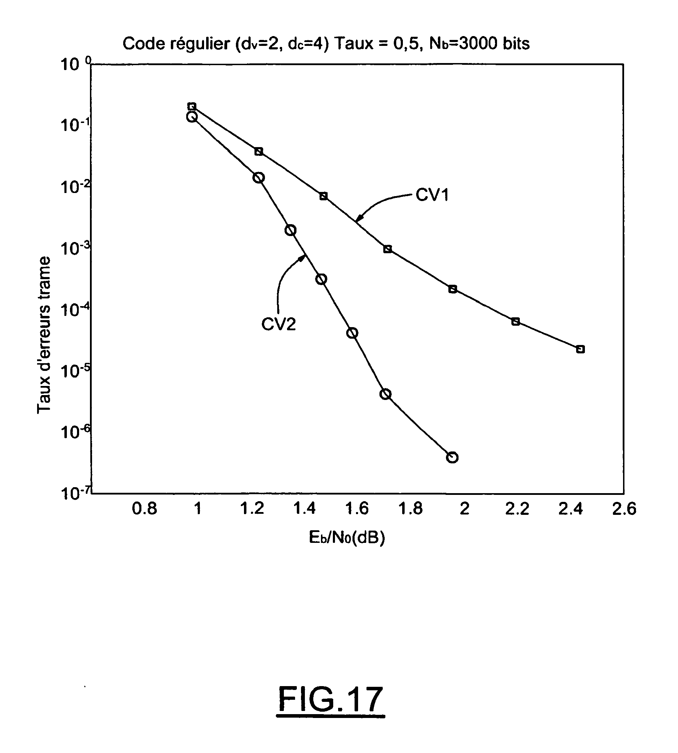

Les figures 16 et 17 illustrent des courbes montrant certains avantages de la présente invention.

Sur la base d'une construction quasi-cyclique, une structure de codes du type subdivisé a été élaborée avec les paramètres suivants :

- taux de code R = 0,5,
- $d_v = 2$,
- $d_c = 4$.

Les noeuds de contrôle sont définis sur le corps de Galois d'ordre q = 64 ($2^6$) et tous les symboles sont subdivisés en deux sous-symboles de taille 3 bits (ns = 2).

Sur la figure 16, le nombre total de bits du jeu de symboles initial est égal à $N_b$ = 864.

Un maximum de 1000 itérations a été fixé et le décodeur a été stoppé en utilisant un critère classique du type « syndrome », bien connu de l'homme du métier.

Sur la figure 17, les mêmes paramètres ont été utilisés mais $N_b$ = 3000 bits.

Sur les figures 16 et 17, l'axe des ordonnées représente le taux d'erreur trame tandis que l'axe des abscisses représente $E_b/N_0$ avec $E_b$ représentant l'énergie moyenne de transmission d'un bit sur le canal et $N_0$ est l'énergie de bruit du canal.

La courbe CV1 représente les performances d'un code LDPC classique sur GF(64) tandis que la courbe CV2 montre les performances pour un code à structure subdivisée. On remarque donc que le code à structure subdivisée présente un plancher d'erreurs bien plus faible.

**Revendications**

1. Procédé d'encodage d'un jeu de K symboles initiaux avec un code du type à contrôle de parité, **caractérisé par le fait que** les K symboles initiaux appartenant à un corps de Galois d'ordre q strictement supérieur à 2, on définit le code par des caractéristiques de code représentables par un graphe (GRH) comportant N-K premiers noeuds (NC;), chaque noeud satisfaisant une équation de contrôle de parité définie sur le corps de Galois d'ordre q, N paquets de noeuds intermédiaires ($NIT_i$) et NI deuxièmes noeuds($NSS_i$), chaque noeud intermédiaire étant relié à un seul premier noeud et à plusieurs deuxièmes noeuds par l'intermédiaire d'un schéma de liaisons, et on encode (20) le jeu (J1) de K symboles initiaux en utilisant lesdites caractéristiques de code et on obtient un jeu (J2) de N symboles encodés respectivement subdivisés en NI sous-symboles appartenant respectivement à des ensembles mathématiques dont les ordres sont inférieurs à q, selon un schéma de subdivision représentatif du schéma de liaisons ($\Pi$).

2. Procédé selon la revendication 1, dans lequel les N paquets de noeuds intermédiaires ($NIT_i$) sont respectivement associés aux N symboles encodés, le schéma de subdivision comporte, pour chaque symbole encodé, le nombre et les emplacements des sous-symboles correspondants au sein dudit jeu, ce nombre et ces emplacements étant représentatifs de la partie du schéma de liaisons ($\Pi$) aboutissant au paquet de noeuds intermédiaires associés audit symbole encodé.

**3.** Procédé selon la revendication 1 ou 2, dans lequel q est égal à $2^p$ avec p strictement supérieur à 1 et chaque ordre inférieur à q est également une puissance entière de 2, et la définition desdites caractéristiques de code comporte une élaboration d'une première matrice (H) possédant N-K groupes de p lignes respectivement associés aux N-K équations de contrôle de parité et N groupes de p colonnes respectivement associés aux N symboles, chaque groupe de p lignes comportant des blocs de bits de p lignes et de p colonnes formant respectivement des images matricielles binaires des coefficients non nuls de l'équation de contrôle de parité associée audit groupe de p lignes considéré, chacun de ces blocs, associé à un symbole, étant subdivisé en j sous-blocs de bits de p lignes et de $p_i$ colonnes respectivement situés à des emplacements différents sur ledit groupe de p lignes, les valeurs des nombres j et $p_i$, i variant de 1 à j, ainsi que les positions des différents emplacements des sous-blocs formant un bloc associé à un symbole encodé étant représentatifs de partie du schéma de subdivision associée audit symbole encodé, et on obtient le jeu de symboles encodés à partir de ladite première matrice et du jeu de symboles initiaux.

**4.** Procédé selon la revendication 3, dans lequel l'élaboration de ladite première matrice (H) comporte une élaboration d'une matrice initiale (MIN) comportant une première partie (E1) représentative des équations de contrôle de parité et une deuxième partie (E2) contenant différentes indications de regroupement respectivement représentatives du schéma de subdivision, et une détermination de ladite première matrice à partir de ladite matrice initiale.

**5.** Procédé selon la revendication 4, dans lequel la première partie (E1) de la matrice initiale comporte N-K lignes dont les éléments appartenant au corps de Galois d'ordre q sont représentatifs des coefficients des différentes équations de contrôle de parité, et la deuxième partie (E2)de la matrice initiale comporte NI lignes respectivement associées aux NI deuxièmes noeuds et dont les éléments forment les différentes indications de regroupement, et la première partie et la deuxième partie de la matrice initiale ont le même nombre de colonnes, ce nombre étant égal au nombre de noeuds intermédiaires.

**6.** Procédé selon la revendication 5, dans lequel on élabore la deuxième partie (E2) de la matrice initiale de façon à obtenir pour ladite matrice initiale un rayon de graphe supérieur ou égal à un seuil désiré.

**7.** Procédé selon la revendication 6, dans lequel le seuil désiré est égal à 6.

**8.** Procédé selon l'une des revendications précédentes, dans lequel les ensembles mathématiques ayant un ordre inférieur à q présentent tous le même ordre.

**9.** Procédé selon l'une des revendications précédentes, dans lequel les ensembles mathématiques sont des corps de Galois

**10.** Procédé selon la revendication 3 prise en combinaison avec la revendication 8 ou 9, dans lequel chaque ordre inférieur à $2^p$ est égal à $2^{p/ns}$, et NI est égal au produit de ns par N.

**11.** Procédé selon l'une des revendications précédentes, dans lequel on fournit également une indication (MIN) représentative du schéma de subdivision des symboles.

**12.** Dispositif d'encodage, **caractérisé par le fait qu'**il comprend une entrée (EN1) pour recevoir un jeu (J1) de K symboles initiaux appartenant à un corps de Galois d'ordre q strictement supérieur à 2, des moyens de stockage (MM1) comportant des caractéristiques de code représentables par un graphe comportant N-K premiers noeuds ($NC_i$), chaque premier noeud satisfaisant une équation de contrôle de parité définie sur le corps de Galois d'ordre q, N paquets de noeuds intermédiaires ($NIT_i$) et NI deuxièmes noeuds($NSS_i$), chaque noeud intermédiaire étant relié à un seul premier noeud de contrôle et à plusieurs deuxièmes noeuds par l'intermédiaire d'un schéma de liaisons ($\Pi$), et des moyens d'encodage (MENC) couplés à l'entrée et aux moyens de stockage et aptes à élaborer un jeu (J2) de N symboles encodés respectivement subdivisés en NI sous-symboles appartenant respectivement à ensembles mathématiques dont les ordres sont inférieurs à q, selon un schéma de subdivision représentatif du schéma de liaisons.

**13.** Dispositif selon la revendication 12, dans lequel les N paquets de noeuds intermédiaires ($NIT_i$) sont respectivement associés aux N symboles encodés, le schéma de subdivision comporte, pour chaque symbole encodé, le nombre et les emplacements des sous-symboles correspondants au sein dudit jeu, ce nombre et ces emplacements étant représentatifs de la partie du schéma de liaisons aboutissant au paquet de noeud intermédiaire associé audit symbole encodé.

**14.** Dispositif selon la revendication 12 ou 13, dans lequel q est égal à $2^p$ avec p supérieur à 1 et chaque ordre inférieur à q est également une puissance entière de 2, le dispositif comprenant en outre des moyens de traitement (MTC) aptes à élaborer une première matrice (H) également représentative des caractéristiques de code, cette première matrice possédant N-K groupes de p lignes respectivement associés aux N-K équations de contrôle de parité et N groupes de p colonnes respectivement associés aux N symboles, chaque groupe de p lignes comportant des blocs de bits de p lignes et de p colonnes formant respectivement des images matricielles binaires des coefficients non nuls de l'équation de contrôle de parité associée audit groupe de p lignes considéré, chacun de ces blocs, associé à un symbole encodé, étant subdivisé en j sous-blocs de bits de p lignes et de $p_j$ colonnes respectivement situés à des emplacements différents sur ledit groupe de p lignes, les valeurs des nombres j et $p_i$, i variant de 1 à j, ainsi que les positions des différents emplacements des sous-blocs formant un bloc associé à un symbole encodé étant représentatifs de partie du schéma de subdivision associées audit symbole encodé, et les moyens d'encodage (MENC) sont aptes à élaborer le jeu de symboles encodés à partir de ladite première matrice.

**15.** Dispositif selon la revendication 14, dans lequel les moyens de traitement sont en outre aptes à élaborer une matrice initiale (MIN) comportant une première partie (E1) représentative des équations de contrôle de parité et une deuxième partie (E2) contenant différentes indications de regroupement respectivement représentatives du schéma de subdivision, et à déterminer ladite première matrice à partir de ladite matrice initiale.

**16.** Dispositif selon la revendication 15, dans lequel la première partie (E1) de la matrice initiale comporte N-K lignes dont les éléments appartenant au corps de Galois d'ordre q sont représentatifs des coefficients des différentes équations de contrôle de parité, et la deuxième partie (E2) de la matrice initiale comporte NI lignes respectivement associées aux NI deuxièmes noeuds et dont les éléments forment les différentes indications de regroupement, et la première partie et la deuxième partie de la matrice initiale ont le même nombre de colonnes, ce nombre étant égal au nombre de noeuds intermédiaires.

**17.** Dispositif selon la revendication 16, dans lequel la matrice initiale présente un rayon de graphe supérieur ou égal à un seuil désiré.

**18.** Dispositif selon la revendication 17, dans lequel le seuil désiré est égal à 6.

**19.** Dispositif selon l'une des revendications 12 à 18, dans lequel les ensembles mathématiques ayant un ordre inférieur à q présentent tous le même ordre.

**20.** Dispositif selon l'une des revendications 12 à 19, dans lequel les ensembles mathématiques ayant un ordre inférieur à q sont des corps de Galois.

**21.** Dispositif selon la revendication 14 prise en combinaison avec la revendication 19 ou 20, dans lequel chaque ordre inférieur à $2^p$ est égal à $2^{p/ns}$, et NI est égal au produit de ns par N.

**22.** Dispositif selon l'une des revendications 12 à 21, dans lequel les moyens d'encodage sont également aptes à délivrer une indication (MIN) représentative du schéma de subdivision des symboles.

**23.** Procédé de décodage d'un jeu de symboles encodés, dans lequel, chaque symbole a été encodé avec un code du type à contrôle de parité défini par des caractéristiques de code représentables par un graphe comportant des premiers noeuds ($NC_i$) satisfaisant chacun une équation de parité, des deuxièmes noeuds et des noeuds intermédiaires ($NIT_i$), chaque noeud intermédiaire étant relié à un seul premier noeud et à plusieurs deuxièmes noeuds par un schéma de liaisons ($\Pi$), chaque symbole encodé du jeu appartient à un corps de Galois d'ordre q strictement supérieur à 2 et est subdivisé en sous-symboles appartenant respectivement à des ensembles mathématiques d'ordres inférieurs à q, selon un schéma de subdivision représentatif du schéma de liaisons et on effectue une mise à jour itérative (1312) des premiers noeuds dans le corps de Galois d'ordre q tandis qu'on effectue une mise à jour itérative (1310) des deuxièmes noeuds dans lesdits ensembles mathématiques d'ordres inférieurs à q, en tenant compte dudit schéma de subdivision.

**24.** Procédé selon la revendication 23, dans lequel on effectue également un traitement (1311, 1313) des noeuds intermédiaires réparti avant et après une mise à jour des premiers noeuds.

**25.** Procédé selon l'une des revendications 23 ou 24, dans lequel la mise à jour itérative des différents noeuds comporte une mise à jour séquentielle des premiers noeuds et des noeuds situés dans le voisinage de chaque premier noeud mis à jour.

**26.** Procédé selon l'une des revendications 23 à 25, dans lequel on effectue les mises à jour en utilisation un algorithme du type à propagation de croyance.

**27.** Procédé selon l'une des revendications 23 à 26, dans lequel q est égal à $2^p$ avec p supérieur à 1 et chaque ordre inférieur à q est également une puissance entière de 2.

**28.** Procédé selon l'une des revendications 23 à 27, dans lequel les ensembles mathématiques ayant un ordre inférieur à q présentent tous le même ordre.

**29.** Procédé selon l'une des revendications 23 à 28, dans lequel les ensembles mathématiques ayant un ordre inférieur à q sont des corps de Galois.

**30.** Procédé selon la revendication 27 prise en combinaison avec la revendication 28 ou 29, dans lequel chaque ordre inférieur à $2^p$ est égal à $2^{p/ns}$.

**31.** Procédé selon l'une des revendications 23 à 30, dans lequel on stocke sous forme matricielle (MIN) les caractéristiques de code correspondant audit graphe.

**32.** Procédé selon la revendication 31, dans lequel on stocke sous forme matricielle (MIN) les différents coefficients des équations de parité ainsi que des informations représentatives du schéma de subdivision des symboles en sous-symboles au sein du jeu.

**33.** Procédé selon la revendication 32, dans lequel ladite matrice (MIN) comporte une première partie (E1) représentative des équations de contrôle de parité et une deuxième partie (E2) contenant différentes indications de regroupement respectivement représentatives des subdivisions des différents symboles encodés.

**34.** Procédé selon la revendication 33, dans lequel on reçoit un jeu de N symboles encodés et on délivre un jeu de K symboles décodés et la première partie (E1) de la matrice (MIN) comporte N-K lignes dont les éléments appartenant au corps de Galois d'ordre q sont représentatifs des coefficients des différentes équations de contrôle de parité, et la deuxième partie (E2) de la matrice comporte NI lignes, respectivement associées aux NI deuxièmes noeuds, dont les éléments forment les différentes indications de regroupement, et la première partie et la deuxième partie de la matrice ont le même nombre de colonnes, ce nombre étant égal au nombre de noeuds intermédiaires.

**35.** Dispositif de décodage, **caractérisé par le fait qu'**il comprend une entrée (EN2) pour recevoir un jeu de symboles encodés avec un code du type à contrôle de parité, chaque symbole encodé du jeu appartient à un corps de Galois d'ordre q strictement supérieur à 2 et étant subdivisé en sous-symboles appartenant respectivement à des ensembles mathématiques d'ordres inférieurs à q, selon un schéma de subdivision, des moyens de stockage (MM2) aptes à stocker des caractéristiques dudit code représentables par un graphe comportant des premiers noeuds satisfaisant chacun une équation de parité, des deuxièmes noeuds et des noeuds intermédiaires, chaque noeud intermédiaire étant relié à un seul premier noeud et à plusieurs deuxièmes noeuds par un schéma de liaisons représentatif su schéma de subdivision, des moyens de décodage (MDEC) couplés à ladite entrée et aux moyens de stockage et aptes à effectuer une mise à jour itérative des premiers noeuds dans le corps de Galois d'ordre q et à effectuer une mise à jour itérative des deuxièmes noeuds dans lesdits ensembles mathématiques d'ordres inférieurs à q, en tenant compte dudit schéma de subdivision.

**36.** Dispositif selon la revendication 35, dans lequel les moyens de décodage (MDEC) sont aptes à effectuer également un traitement des noeuds intermédiaires réparti avant et après une mise à jour des premiers noeuds.

**37.** Dispositif selon l'une des revendications 35 ou 36, dans lequel les moyens de décodage sont aptes à mettre à jour de façon séquentielle les différents premiers noeuds ($NC_i$) ainsi que les noeuds situés dans le voisinage de chaque premier noeud destiné à être mis à jour.

**38.** Dispositif selon l'une des revendications 35 à 37, dans lequel les moyens de décodage (MDEC) sont aptes à mettre en oeuvre un algorithme du type à propagation de croyance.

**39.** Dispositif selon l'une des revendications 35 à 38, dans lequel q est égal à $2^p$ avec p supérieur à 1 et chaque ordre inférieur à q est également une puissance entière de 2.

**40.** Dispositif selon l'une des revendications 35 à 39, dans lequel les ensembles mathématiques ayant un ordre inférieur à q présentent tous le même ordre.

**41.** Dispositif selon l'une des revendications 35 à 40, dans lequel les ensembles mathématiques ayant un ordre inférieur à q sont des corps de Galois.

**42.** Dispositif selon la revendication 39 prise en combinaison avec la revendication 40 ou 41, dans lequel chaque ordre inférieur à $2^p$ est égal à $2^{p/ns}$.

**43.** Dispositif selon l'une des revendications 35 à 42, dans lequel les moyens de stockage (MM2) sont aptes à stocker sous forme matricielle les caractéristiques de code correspondant audit graphe.

**44.** Dispositif selon la revendication 43, dans lequel ladite matrice (MIN) contient les différents coefficients des équations de parité ainsi que des informations représentatives du schéma de subdivision des symboles en sous-symboles au sein du jeu.

**45.** Dispositif selon la revendication 44, dans lequel ladite matrice (MIN) comporte une première partie (E1) représentative des équations de contrôle de parité et une deuxième partie (E2) contenant différentes indications de regroupement respectivement représentatives des subdivisions des différents symboles encodés.

**46.** Dispositif selon la revendication 45, dans lequel la première partie (E1) de la matrice (MIN) comporte N-K lignes dont les éléments appartenant au corps de Galois d'ordre q sont représentatifs des coefficients des différentes équations de contrôle de parité, et la deuxième partie de la matrice comporte NI lignes, respectivement associées aux NI deuxièmes noeuds, dont les éléments forment les différentes indications de regroupement, et la première partie et la deuxième partie de la matrice ont le même nombre de colonnes, ce nombre étant égal au nombre de noeuds intermédiaires, et ladite entrée est apte à recevoir un jeu de N symboles encodés et les moyens de décodage (MDEC) sont aptes à délivrer un jeu de K symboles décodés à partir de ladite matrice et du jeu de N symboles.

**47.** Appareil de communication, couplé à un canal de transmission et comportant un dispositif d'encodage selon l'une des revendications 12 à 22.

**48.** Appareil de communication, couplé à un canal de transmission et comportant un dispositif de décodage selon l'une des revendications 35 à 46.


**Claims**

**1.** Method for encoding a set of K initial symbols with a code of the parity check type, **characterized in that** the K initial symbols belonging to a Galois field of order q strictly greater than 2, the code is defined by code characteristics representable by a graph (GRH) comprising N-K first nodes ($NC_i$), each node satisfying a parity check equation defined on the Galois field of order q, N packets of intermediate nodes ($NIT_i$) and NI second nodes ($NSS_i$), each intermediate node being linked to a single first node and to several second nodes by way of a connection scheme, and the set (J1) of K initial symbols is encoded (20) by using the said code characteristics and a string (J2) of N encoded symbols is obtained, respectively subdivided into NI sub-symbols belonging respectively to mathematical sets whose orders are less than q, according to a subdivision scheme representative of the connection scheme ($\Pi$).

**2.** Method according to Claim 1, in which the N packets of intermediate nodes ($NIT_i$) are respectively associated with the N encoded symbols, the subdivision scheme comprises, for each encoded symbol, the number and the locations of the corresponding sub-symbols within the said set, this number and these locations being representative of the part of the connection scheme ($\Pi$) ending up at the packet of intermediate nodes associated with the said encoded symbol.

**3.** Method according to Claim 1 or 2, in which q is equal to $2^p$ with p strictly greater than 1 and each order less than q is also an integer power of 2, and the definition of the said code characteristics comprises a formulation of a first matrix (H) possessing N-K groups of p rows respectively associated with the N-K parity check equations and N groups of p columns respectively associated with the N symbols, each group of p rows comprising bit blocks of p rows and of p columns forming respectively binary matrix images of the nonzero coefficients of the parity check equation associated with the said group of p rows considered, each of these blocks, associated with a symbol, being subdivided into j bit sub-blocks of p rows and of $p_i$ columns respectively situated at different locations on the said group of p rows, the values of the numbers j and $p_i$, i varying from 1 to j, as well as the positions of the various locations of the sub-blocks forming a block associated with an encoded symbol being representative of part of the subdivision scheme associated with the said encoded symbol, and the set of encoded symbols is obtained on the basis of the said first matrix and of the set of initial symbols.

4. Method according to Claim 3, in which the formulation of the said first matrix (H) comprises a formulation of an initial matrix (MIN) comprising a first part (E1) representative of the parity check equations and a second part (E2) containing various grouping indications respectively representative of the subdivision scheme, and a determination of the said first matrix on the basis of the said initial matrix.

5. Method according to Claim 4, in which the first part (E1) of the initial matrix comprises N-K rows whose elements belonging to the Galois field of order q are representative of the coefficients of the various parity check equations, and the second part (E2) of the initial matrix comprises NI rows respectively associated with the NI second nodes and whose elements form the various grouping indications, and the first part and the second part of the initial matrix have the same number of columns, this number being equal to the number of intermediate nodes.

6. Method according to Claim 5, in which the second part (E2) of the initial matrix is formulated so as to obtain for the said initial matrix a graph radius greater than or equal to a desired threshold.

7. Method according to Claim 6, in which the desired threshold is equal to 6.

8. Method according to one of the preceding claims, in which the mathematical sets having an order less than q all exhibit the same order.

9. Method according to one of the preceding claims, in which the mathematical sets are Galois fields.

10. Method according to Claim 3 taken in combination with Claim 8 or 9, in which each order less than $2^p$ is equal to $2^{p/ns}$, and NI is equal to the product of ns times N.

11. Method according to one of the preceding claims, in which an indication (MIN) representative of the symbols subdivision scheme is also provided.

12. Encoding device, **characterized in that** it comprises an input (EN1) for receiving a set (J1) of K initial symbols belonging to a Galois field of order q strictly greater than 2, storage means (MM1) comprising code characteristics representable by a graph comprising N-K first nodes ($NC_i$), each first node satisfying a parity check equation defined on the Galois field of order q, N packets of intermediate nodes ($NIT_i$) and NI second nodes ($NSS_i$), each intermediate node being linked to a single first check node and to several second nodes by way of a connection scheme ($\Pi$), and encoding means (MENC) coupled to the input and to the storage means and able to formulate a set (J2) of N encoded symbols respectively subdivided into NI sub-symbols belonging respectively to mathematical sets whose orders are less than q, according to a subdivision scheme representative of the connection scheme.

13. Device according to Claim 12, in which the N packets of intermediate nodes ($NIT_i$) are respectively associated with the N encoded symbols, the subdivision scheme comprises, for each encoded symbol, the number and the locations of the corresponding sub-symbols within the said set, this number and these locations being representative of the part of the connection scheme ending up at the intermediate node packet associated with the said encoded symbol.

14. Device according to Claim 12 or 13, in which q is equal to $2^p$ with p greater than 1 and each order less than q is also an integer power of 2, the device furthermore comprising processing means (MTC) able to formulate a first matrix (H) also representative of the code characteristics, this first matrix possessing N-K groups of p rows respectively associated with the N-K parity check equations and N groups of p columns respectively associated with the N symbols, each group of p rows comprising bit blocks of p rows and of p columns forming respectively binary matrix images of the nonzero coefficients of the parity check equation associated with the said group of p rows considered, each of these blocks, associated with an encoded symbol, being subdivided into j bit sub-blocks of p rows and of $p_j$ columns respectively situated at different locations on the said group of p rows, the values of the numbers j and $p_i$, i varying from 1 to j, as well as the positions of the various locations of the sub-blocks forming a block associated with an encoded symbol being representative of part of the subdivision scheme associated with the said encoded symbol, and the encoding means (MENC) are able to formulate the set of encoded symbols on the basis of the said first matrix.

15. Device according to Claim 14, in which the processing means are furthermore able to formulate an initial matrix (MIN) comprising a first part (E1) representative of the parity check equations and a second part (E2) containing various grouping indications respectively representative of the subdivision scheme, and to determine the said first matrix on the basis of the said initial matrix.

16. Device according to Claim 15, in which the first part (E1) of the initial matrix comprises N-K rows whose elements belonging to the Galois field of order q are representative of the coefficients of the various parity check equations, and the second part (E2) of the initial matrix comprises NI rows respectively associated with the NI second nodes and whose elements form the various grouping indications, and the first part and the second part of the initial matrix have the same number of columns, this number being equal to the number of intermediate nodes.

17. Device according to Claim 16, in which the initial matrix exhibits a graph radius greater than or equal to a desired threshold.

18. Device according to Claim 17, in which the desired threshold is equal to 6.

19. Device according to one of Claims 12 to 18, in which the mathematical sets having an order less than q all exhibit the same order.

20. Device according to one of Claims 12 to 19, in which the mathematical sets having an order less than q are Galois fields.

21. Device according to Claim 14 taken in combination with Claim 19 or 20, in which each order less than $2^p$ is equal to $2^{p/ns}$, and NI is equal to the product of ns times N.

22. Device according to one of Claims 12 to 21, in which the encoding means are also able to deliver an indication (MIN) representative of the symbols subdivision scheme.

23. Method for decoding a set of encoded symbols, in which each symbol has been encoded with a code of the parity check type defined by code characteristics representable by a graph comprising first nodes ($NC_i$) each satisfying a parity equation, second nodes and intermediate nodes ($NIT_i$), each intermediate node being linked to a single first node and to several second nodes by a connection scheme ($\Pi$), each encoded symbol of the set belongs to a Galois field of order q strictly greater than 2 and is subdivided into sub-symbols belonging respectively to mathematical sets of orders less than q, according to a subdivision scheme representative of the connection scheme and an iterative update (1312) of the first nodes in the Galois field of order q is performed while an iterative update (1310) of the second nodes in the said mathematical sets of orders less than q is performed, taking account of the said subdivision scheme.

24. Method according to Claim 23, in which a processing (1311, 1313) of the intermediate nodes is also performed, distributed before and after an update of the first nodes.

25. Method according to one of Claims 23 or 24, in which the iterative update of the various nodes comprises a sequential update of the first nodes and of the nodes situated in the neighbourhood of each updated first node.

26. Method according to one of Claims 23 to 25, in which the updates are performed using an algorithm of the belief propagation type.

27. Method according to one of Claims 23 to 26, in which q is equal to $2^p$ with p greater than 1 and each order less than q is also an integer power of 2.

28. Method according to one of Claims 23 to 27, in which the mathematical sets having an order less than q all exhibit the same order.

29. Method according to one of Claims 23 to 28, in which the mathematical sets having an order less than q are Galois fields.

**30.** Method according to Claim 27 taken in combination with Claim 28 or 29, in which each order less than $2^p$ is equal to $2^{p/ns}$.

**31.** Method according to one of Claims 23 to 30, in which the code characteristics corresponding to the said graph are stored in matrix form (MIN).

**32.** Method according to Claim 31, in which the various coefficients of the parity equations as well as information representative of the scheme for subdividing the symbols into sub-symbols within the set are stored in matrix form (MIN).

**33.** Method according to Claim 32, in which the said matrix (MIN) comprises a first part (E1) representative of the parity check equations and a second part (E2) containing various grouping indications respectively representative of the subdivisions of the various encoded symbols.

**34.** Method according to Claim 33, in which a set of N encoded symbols is received and a set of K decoded symbols is delivered and the first part (E1) of the matrix (MIN) comprises N-K rows whose elements belonging to the Galois field of order q are representative of the coefficients of the various parity check equations, and the second part (E2) of the matrix comprises NI rows, respectively associated with the NI second nodes, whose elements form the various grouping indications, and the first part and the second part of the matrix have the same number of columns, this number being equal to the number of intermediate nodes.

**35.** Decoding device, **characterized in that** it comprises an input (EN2) for receiving a set of symbols encoded with a code of the parity check type, each encoded symbol of the set belongs to a Galois field of order q strictly greater than 2 and being subdivided into sub-symbols belonging respectively to mathematical sets of orders less than q, according to a subdivision scheme, storage means (MM2) able to store characteristics of the said code that are representable by a graph comprising first nodes each satisfying a parity equation, second nodes and intermediate nodes, each intermediate node being linked to a single first node and to several second nodes by a connection scheme representative of the subdivision scheme, decoding means (MDEC) coupled to the said input and to the storage means and able to perform an iterative update of the first nodes in the Galois field of order q and to perform an iterative update of the second nodes in the said mathematical sets of orders less than q, taking account of the said subdivision scheme.

**36.** Device according to Claim 35, in which the decoding means (MDEC) are also able to perform a processing of the intermediate nodes that is distributed before and after an update of the first nodes.

**37.** Device according to one of Claims 35 or 36, in which the decoding means are able to update in a sequential manner the various first nodes ($NC_i$) as well as the nodes situated in the neighbourhood of each first node intended to be updated.

**38.** Device according to one of Claims 35 to 37, in which the decoding means (MDEC) are able to implement an algorithm of the belief propagation type.

**39.** Device according to one of Claims 35 to 38, in which q is equal to $2^p$ with p greater than 1 and each order less than q is also an integer power of 2.

**40.** Device according to one of Claims 35 to 39, in which the mathematical sets having an order less than q all exhibit the same order.

**41.** Device according to one of Claims 35 to 40, in which the mathematical sets having an order less than q are Galois fields.

**42.** Device according to Claim 39 taken in combination with Claim 40 or 41, in which each order less than $2^p$ is equal to $2^{p/ns}$.

**43.** Device according to one of Claims 35 to 42, in which the storage means (MM2) are able to store in matrix form the code characteristics corresponding to the said graph.

**44.** Device according to Claim 43, in which the said matrix (MIN) contains the various coefficients of the parity equations as well as information representative of the scheme for subdividing the symbols into sub-symbols within the set.

**45.** Device according to Claim 44, in which the said matrix (MIN) comprises a first part (E1) representative of the parity check equations and a second part (E2) containing various grouping indications respectively representative of the subdivisions of the various encoded symbols.

**46.** Device according to Claim 45, in which the first part (E1) of the matrix (MIN) comprises N-K rows whose elements belonging to the Galois field of order q are representative of the coefficients of the various parity check equations, and the second part of the matrix comprises NI rows, respectively associated with the NI second nodes, whose elements form the various grouping indications, and the first part and the second part of the matrix have the same number of columns, this number being equal to the number of intermediate nodes, and the said input is able to receive a set of N encoded symbols and the decoding means (MDEC) are able to deliver a set of K symbols decoded on the basis of the said matrix and of the set of N symbols.

**47.** Communication facility, coupled to a transmission channel and comprising an encoding device according to one of Claims 12 to 22.

**48.** Communication facility, coupled to a transmission channel and comprising a decoding device according to one of Claims 35 to 46.

**Patentansprüche**

**1.** Verfahren zum Codieren eines Satzes von K Anfangssymbolen mit einem Code vom Typ mit Paritätsprüfung, **dadurch gekennzeichnet, dass**, wenn die K Anfangssymbole zu einem Galois-Körper der Ordnung q strikt höher als 2 gehören, der Code durch mittels eines Graphs (GRH) darstellbare Code-Eigenschaften definiert wird, der N-K erste Knoten ($NC_i$), wobei jeder Knoten eine Paritätsprüfungsgleichung erfüllt, die im Galois-Körper der Ordnung q definiert ist, N Pakete von Zwischenknoten ($NIT_i$) und NI zweite Knoten ($NSS_i$) aufweist, wobei jeder Zwischenknoten mit einem einzigen ersten Knoten und mit mehreren zweiten Knoten mittels eines Verbindungsschemas verbunden ist, und der Satz (J1) von K Anfangssymbolen unter Verwendung der Code-Eigenschaften codiert wird (20), und ein Satz (J2) von N codierten Symbolen erhalten wird, die je in NI Teilsymbole unterteilt sind, welche je zu mathematischen Einheiten gehören, deren Ordnungen geringer als q sind, gemäß einem Unterteilungsschema, das für das Verbindungsschema (n) repräsentativ ist.

**2.** Verfahren nach Anspruch 1, bei dem die N Pakete von Zwischenknoten ($NIT_i$) je den codierten N Symbolen zugeordnet sind, wobei das Unterteilungsschema für jedes codierte Symbol die Anzahl und die Stellen der entsprechenden Teilsymbole innerhalb des Satzes enthält, wobei diese Anzahl und diese Stellen für den Bereich des Verbindungsschemas ($\Pi$) repräsentativ sind, der zum Paket von Zwischenknoten führt, die dem codierten Symbol zugeordnet sind.

**3.** Verfahren nach Anspruch 1 oder 2, bei dem q gleich $2^p$ mit p strikt höher als 1 ist, und jede Ordnung geringer als q ebenfalls eine ganzzahlige Potenz von 2 ist, und die Definition der Code-Eigenschaften eine Erarbeitung einer ersten Matrix (H) aufweist, die N-K Gruppen von p Zeilen, die jeweils den N-K Paritätsprüfungsgleichungen zugeordnet sind, und N Gruppen von p Spalten besitzt, die je den N Symbolen zugeordnet sind, wobei jede Gruppe von p Zeilen Bitblöcke von p Zeilen und von p Spalten aufweist, die je binäre Matrixbilder der Koeffizienten ungleich Null der Paritätsprüfungsgleichung formen, die der betrachteten Gruppe von p Zeilen zugeordnet ist, wobei jeder dieser einem Symbol zugeordneten Blöcke in j Teilbitblöcke von p Zeilen bzw. von $p_i$ Spalten unterteilt ist, die sich an verschiedenen Stellen in der Gruppe von p Zeilen befinden, wobei die Werte der Zahlen j und $p_i$, wobei i von 1 bis j variiert, sowie die Positionen der verschiedenen Stellen der Teilblöcke, die einen einem codierten Symbol zugeordneten Block formen, für einen Bereich des Unterteilungsschemas repräsentativ sind, der dem codierten Symbol zugeordnet ist, und der Satz von codierten Symbolen ausgehend von der ersten Matrix und dem Satz von Anfangssymbolen erhalten wird.

**4.** Verfahren nach Anspruch 3, bei dem die Erarbeitung der ersten Matrix (H) eine Erarbeitung einer Anfangsmatrix (MIN) aufweist, die einen ersten Bereich (E1), der für die Paritätsprüfungsgleichungen repräsentativ ist, und einen zweiten Bereich (E2) aufweist, der verschiedene Gruppierungsangaben, die je für das Unterteilungsschema repräsentativ sind, und eine Bestimmung der ersten Matrix ausgehend von der Anfangsmatrix enthält.

**5.** Verfahren nach Anspruch 4, bei dem der erste Bereich (E1) der Anfangsmatrix N-K Zeilen aufweist, deren zum Galois-Körper der Ordnung q gehörende Elemente für die Koeffizienten der verschiedenen Paritätsprüfungsgleichungen repräsentativ sind, und der zweite Bereich (E2) der Anfangsmatrix NI Zeilen aufweist, die je den NI zweiten Knoten zugeordnet sind und deren Elemente die verschiedenen Gruppierungsangaben formen, und der erste Bereich und der zweite Bereich der Anfangsmatrix die gleiche Anzahl von Spalten haben, wobei diese Anzahl gleich der Anzahl von Zwischenknoten ist.

**6.** Verfahren nach Anspruch 5, bei dem der zweite Bereich (E2) der Anfangsmatrix erarbeitet wird, um für die Anfangsmatrix einen Graphradius zu erhalten, der größer als der oder gleich einem gewünschten Schwellwert ist.

**7.** Verfahren nach Anspruch 6, bei dem der gewünschte Schwellwert gleich 6 ist.

**8.** Verfahren nach einem der vorhergehenden Ansprüche, bei dem die mathematischen Einheiten, die eine Ordnung geringer als q haben, alle die gleiche Ordnung aufweisen.

**9.** Verfahren nach einem der vorhergehenden Ansprüche, bei dem die mathematischen Einheiten Galois-Körper sind.

**10.** Verfahren nach Anspruch 3 in Kombination mit Anspruch 8 oder 9, bei dem jede Ordnung geringer als $2^p$ gleich $2^{p/ns}$ und NI gleich dem Produkt aus ns und N ist.

**11.** Verfahren nach einem der vorhergehenden Ansprüche, bei dem ebenfalls eine Angabe (MIN) geliefert wird, die für das Unterteilungsschema der Symbole repräsentativ ist.

**12.** Codiervorrichtung, **dadurch gekennzeichnet, dass** sie einen Eingang (EN1) für den Empfang eines Satzes (J1) von K Anfangssymbolen, die zu einem Galois-Körper der Ordnung q strikt höher als 2 gehören, Speichereinrichtungen (MM1), die mittels eines Graphs darstellbare Code-Eigenschaften aufweisen, der N-K erste Knoten ($NC_i$), wobei jeder erste Knoten eine Paritätsprüfungsgleichung erfüllt, die im Galois-Körper der Ordnung q definiert ist, N Pakete von Zwischenknoten ($NIT_i$) und NI zweite Knoten ($NSS_i$) aufweist, wobei jeder Zwischenknoten mit einem einzigen ersten Prüfknoten und mit mehreren zweiten Knoten über ein Verbindungsschema ($\Pi$) verbunden ist, und Codiereinrichtungen (MENC) enthält, die mit dem Eingang und mit den Speichereinrichtungen gekoppelt sind und einen Satz (J2) von N codierten Symbolen erarbeiten können, die je in NI Teilsymbole unterteilt sind, welche je zu mathematischen Einheiten gehören, deren Ordnungen geringer als q sind, gemäß einem Unterteilungsschema, das für das Verbindungsschema repräsentativ ist.

**13.** Vorrichtung nach Anspruch 12, bei der die N Pakete von Zwischenknoten ($NIT_i$) je den N codierten Symbolen zugeordnet sind, das Unterteilungsschema für jedes codierte Symbol die Anzahl und die Stellen der entsprechenden Teilsymbole innerhalb des Satzes enthält, wobei diese Anzahl und diese Stellen für den Bereich des Verbindungsschemas repräsentativ sind, der zum Zwischenknotenpaket führt, das dem codierten Symbol zugeordnet ist.

**14.** Vorrichtung nach Anspruch 12 oder 13, bei der q gleich $2^p$ mit p strikt höher als 1 ist, und jede Ordnung geringer als q ebenfalls eine ganzzahlige Potenz von 2 ist, wobei die Vorrichtung außerdem Verarbeitungseinrichtungen (MTC) enthält, die eine erste Matrix (H) erarbeiten können, welche ebenfalls für die Code-Eigenschaften repräsentativ ist, wobei diese erste Matrix N-K Gruppen von p Zeilen, die jeweils den N-K Paritätsprüfungsgleichungen zugeordnet sind, und N Gruppen von p Spalten besitzt, die je den N Symbolen zugeordnet sind, wobei jede Gruppe von p Zeilen Bitblöcke von p Zeilen und von p Spalten aufweist, die je binäre Matrixbilder der Koeffizienten ungleich Null der Paritätsprüfungsgleichung formen, die der betrachteten Gruppe von p Zeilen zugeordnet ist, wobei jeder dieser einem codierten Symbol zugeordneten Blöcke in j Teilblöcke von Bits von p Zeilen bzw. von $p_j$ Spalten unterteilt ist, die sich an verschiedenen Stellen in der Gruppe von p Zeilen befinden, wobei die Werte der Anzahlen j und $p_i$, wobei i von 1 bis j variiert, sowie die Positionen der verschiedenen Stellen der Teilblöcke, die einen einem codierten Symbol zugeordneten Block formen, für den Bereich des Unterteilungsschemas repräsentativ sind, der dem codierten Symbol zugeordnet ist, und die Codiereinrichtungen (MENC) den Satz von codierten Symbolen ausgehend von der ersten Matrix erarbeiten können.

**15.** Vorrichtung nach Anspruch 14, bei der die Verarbeitungseinrichtungen außerdem eine Anfangsmatrix (MIN) erarbeiten können, die einen ersten Bereich (E1), der für die Paritätsprüfungsgleichungen repräsentativ ist, und einen zweiten Bereich (E2) aufweist, der verschiedene Gruppierungsangaben enthält, die je für das Unterteilungsschema repräsentativ sind, und die erste Matrix ausgehend von der Anfangsmatrix bestimmen können.

**16.** Vorrichtung nach Anspruch 15, bei der der erste Bereich (E1) der Anfangsmatrix N-K Zeilen aufweist, deren zum Galois-Körper der Ordnung q gehörende Elemente für Koeffizienten der verschiedenen Paritätsprüfungsgleichungen repräsentativ sind, und der zweite Bereich (E2) der Anfangsmatrix NI Zeilen aufweist, die je den NI zweiten Knoten zugeordnet sind und deren Elemente die verschiedenen Gruppierungsangaben formen, und der erste Bereich und der zweite Bereich der Anfangsmatrix die gleiche Anzahl von Spalten haben, wobei diese Anzahl gleich der Anzahl von Zwischenknoten ist.

**17.** Vorrichtung nach Anspruch 16, bei der die Anfangsmatrix einen Graphradius aufweist, der größer als der oder gleich einem gewünschten Schwellwert ist.

**18.** Vorrichtung nach Anspruch 17, bei der der gewünschte Schwellwert gleich 6 ist.

**19.** Vorrichtung nach einem der Ansprüche 12 bis 18, bei der die mathematischen Einheiten, die eine Ordnung geringer als q haben, alle die gleiche Ordnung aufweisen.

**20.** Vorrichtung nach einem der Ansprüche 12 bis 19, bei der die mathematischen Einheiten, die eine Ordnung geringer als q haben, Galois-Körper sind.

**21.** Vorrichtung nach Anspruch 14 in Kombination mit Anspruch 19 oder 20, bei der jede Ordnung geringer als $2^p$ gleich $2^{p/ns}$ und NI gleich dem Produkt aus ns und N ist.

**22.** Vorrichtung nach einem der Ansprüche 12 bis 21, bei der die Codiereinrichtungen ebenfalls eine Angabe (MIN) liefern können, die für das Unterteilungsschema der Symbole repräsentativ ist.

**23.** Verfahren zur Decodierung eines Satzes von codierten Symbolen, bei dem jedes Symbol mit einem Code vom Typ mit Paritätsprüfung codiert wurde, der durch mittels eines Graphs darstellbare Code-Eigenschaften definiert wird, der erste Knoten ($NC_i$), die je eine Paritätsgleichung erfüllen, zweite Knoten und Zwischenknoten ($NIT_i$) aufweist, wobei jeder Zwischenknoten mit einem einzigen ersten Knoten und mit mehreren zweiten Knoten mittels eines Verbindungsschemas ($\Pi$) verbunden ist, wobei jedes codierte Symbol des Satzes zu einem Galois-Körper der Ordnung q strikt höher als 2 gehört und in Teilsymbole unterteilt ist, die je zu mathematischen Einheiten gehören, deren Ordnungen geringer als q sind, gemäß einem Unterteilungsschema, das für das Verbindungsschema repräsentativ ist, und eine iterative Aktualisierung (1312) der ersten Knoten im Galois-Körper der Ordnung q durchgeführt wird, während eine iterative Aktualisierung (1310) der zweiten Knoten in den mathematischen Einheiten der Ordnungen geringer als q durchgeführt wird, unter Berücksichtigung des Unterteilungsschemas.

**24.** Verfahren nach Anspruch 23, bei dem ebenfalls eine Verarbeitung (1311, 1313) der Zwischenknoten durchgeführt wird, die vor und nach einer Aktualisierung der ersten Knoten verteilt ist.

**25.** Verfahren nach einem der Ansprüche 23 oder 24, bei dem die iterative Aktualisierung der verschiedenen Knoten eine sequentielle Aktualisierung der ersten Knoten und der in der Nähe jedes ersten aktualisierten Knotens befindlichen Knoten aufweist.

**26.** Verfahren nach einem der Ansprüche 23 bis 25, bei dem die Aktualisierungen unter Verwendung eines Algorithmus des Typs mit Belief Propagation durchgeführt werden.

**27.** Verfahren nach einem der Ansprüche 23 bis 26, bei dem q gleich $2^p$ mit p größer als 1 ist, und jede Ordnung geringer als q ebenfalls eine ganzzahlige Potenz von 2 ist.

**28.** Verfahren nach einem der Ansprüche 23 bis 27, bei dem die mathematischen Einheiten, die eine Ordnung geringer als q haben, alle die gleiche Ordnung aufweisen.

**29.** Verfahren nach einem der Ansprüche 23 bis 28, bei dem die mathematischen Einheiten, die eine Ordnung geringer als q haben, Galois-Körper sind.

**30.** Verfahren nach Anspruch 27 in Kombination mit Anspruch 28 oder 29, bei dem jede Ordnung geringer als $2^p$ gleich $2^{p/ns}$ ist.

**31.** Verfahren nach einem der Ansprüche 23 bis 30, bei dem die dem Graph entsprechenden Code-Eigenschaften in Matrixform (MIN) gespeichert werden.

32. Verfahren nach Anspruch 31, bei dem die verschiedenen Koeffizienten der Paritätsgleichungen sowie für das Unterteilungsschema der Symbole in Teilsymbole innerhalb des Satzes repräsentative Informationen in Matrixform (MIN) gespeichert werden.

33. Verfahren nach Anspruch 32, bei dem die Matrix (MIN) einen ersten Bereich (E1), der für die Paritätsprüfungsgleichungen repräsentativ ist, und einen zweiten Bereich (E2) aufweist, der verschiedene Gruppierungsangaben enthält, die je für die Unterteilungen der verschiedenen codierten Symbole repräsentativ sind.

34. Verfahren nach Anspruch 33, bei dem ein Satz von N codierten Symbolen empfangen und ein Satz von K decodierten Symbolen geliefert wird, und der erste Bereich (E1) der Matrix (MIN) N-K Zeilen aufweist, deren zum Galois-Körper der Ordnung q gehörende Elemente für die Koeffizienten der verschiedenen Paritätsprüfungsgleichungen repräsentativ sind, und der zweite Bereich (E2) der Matrix NI Zeilen aufweist, die je den NI zweiten Knoten zugeordnet sind, deren Elemente die verschiedenen Gruppierungsangaben formen, und der erste Bereich und der zweite Bereich der Matrix die gleiche Anzahl von Spalten haben, wobei diese Anzahl gleich der Anzahl von Zwischenknoten ist.

35. Decodiervorrichtung, **dadurch gekennzeichnet, dass** sie einen Eingang (EN2) für den Empfang eines Satzes von mit einem Code vom Typ mit Paritätsprüfung codierten Symbolen, wobei jedes codierte Symbol des Satzes zu einem Galois-Körper der Ordnung q strikt höher als 2 gehört und in Teilsymbole unterteilt ist, die je zu mathematischen Einheiten von Ordnungen geringer als q gehören, gemäß einem Unterteilungsschema, Speichereinrichtungen (MM2), die mittels eines Graphs darstellbare Eigenschaften des Codes speichern können, der erste Knoten, die jeder eine Paritätsgleichung erfüllen, zweite Knoten und Zwischenknoten aufweist, wobei jeder Zwischenknoten mit einem einzigen ersten Knoten und mit mehreren zweiten Knoten durch ein Verbindungsschema verbunden ist, das für das Unterteilungsschema repräsentativ ist, und Decodiereinrichtungen (MDEC) enthält, die mit dem Eingang und mit den Speichereinrichtungen gekoppelt sind und eine iterative Aktualisierung der ersten Knoten im Galois-Körper der Ordnung q und eine iterative Aktualisierung der zweiten Knoten in den mathematischen Einheiten der Ordnungen geringer als q durchführen können, unter Berücksichtigung des Unterteilungsschemas.

36. Vorrichtung nach Anspruch 35, bei der die Decodiereinrichtungen (MDEC) ebenfalls eine Verarbeitung der Zwischenknoten durchführen können, die vor und nach einer Aktualisierung der ersten Knoten verteilt ist.

37. Vorrichtung nach einem der Ansprüche 35 oder 36, bei der die Decodiereinrichtungen die verschiedenen ersten Knoten ($NC_i$) sowie die Knoten sequentiell aktualisieren können, die sich in der Nähe jedes ersten zu aktualisierenden Knotens befinden.

38. Vorrichtung nach einem der Ansprüche 35 bis 37, bei der die Decodiereinrichtungen (MDEC) einen Algorithmus vom Typ mit Belief Propagation anwenden können.

39. Vorrichtung nach einem der Ansprüche 35 bis 38, bei der q gleich $2^p$ mit p höher als 1 ist, und jede Ordnung geringer als q ebenfalls eine ganzzahlige Potenz von 2 ist.

40. Vorrichtung nach einem der Ansprüche 35 bis 39, bei der die mathematischen Einheiten, die eine Ordnung geringer als q haben, alle die gleiche Ordnung aufweisen.

41. Vorrichtung nach einem der Ansprüche 35 bis 40, bei der die mathematischen Einheiten, die eine Ordnung geringer als q haben, Galois-Körper sind.

42. Vorrichtung nach Anspruch 39 in Kombination mit Anspruch 40 oder 41, bei der jede Ordnung geringer als $2^p$ gleich $2^{p/ns}$ ist.

43. Vorrichtung nach einem der Ansprüche 35 bis 42, bei der die Speichereinrichtungen (MM2) die dem Graph entsprechenden Code-Eigenschaften in Matrixform speichern können.

44. Vorrichtung nach Anspruch 43, bei der die Matrix (MIN) die verschiedenen Koeffizienten der Paritätsgleichungen sowie für das Unterteilungsschema der Symbole in Teilsymbole innerhalb des Satzes repräsentative Informationen enthält.

**45.** Vorrichtung nach Anspruch 44, bei der die Matrix (MIN) einen für die Paritätsprüfungsgleichungen repräsentativen ersten Bereich (E1) und einen zweiten Bereich (E2) aufweist, der verschiedene Gruppierungsangaben enthält, die je für die Unterteilungen der verschiedenen codierten Symbole repräsentativ sind.

**46.** Vorrichtung nach Anspruch 45, bei der der erste Bereich (E1) der Matrix (MIN) N-K Zeilen, deren zum Galois-Körper der Ordnung q gehörende Elemente für die Koeffizienten der verschiedenen Paritätsprüfungsgleichungen repräsentativ sind, und der zweite Bereich der Matrix NI Zeilen aufweist, die je den NI zweiten Knoten zugeordnet sind, deren Elemente die verschiedenen Gruppierungsangaben formen, und der erste Bereich und der zweite Bereich der Matrix die gleiche Anzahl von Spalten haben, wobei diese Anzahl gleich der Anzahl von Zwischenknoten ist, und der Eingang einen Satz von N codierten Symbolen empfangen kann und die Decodiereinrichtungen (MDEC) einen Satz von K decodierten Symbolen ausgehend von der Matrix und dem Satz von N Symbolen liefern können.

**47.** Kommunikationsgerät, das mit einem Übertragungskanal gekoppelt ist und eine Codiervorrichtung nach einem der Ansprüche 12 bis 22 aufweist.

**48.** Kommunikationsgerät, das mit einem Übertragungskanal gekoppelt ist und eine Decodiervorrichtung nach einem der Ansprüche 35 bis 46 aufweist.

K Symboles initiaux

DENC

N Symboles encodés

EN1

MENC

SOR1

MM1

ANT

MDM

CHN

APP1

SOR2

K Symboles décodés

EN2

ANT

MDEC

DMDM

N

MM2

DDC

APP2

<u>FIG.1</u>

EP 2 198 523 B1

J1

K Symboles
initiaux

MM1

20 —— Encodage

Caractéristiques
de
code

J2

NI sous-symboles encodés

N symboles encodés

# FIG.2

GRH

NSS$_j$

π

NIT$_i$

NC$_i$

<u>FIG.3</u>

A$_1$    A$_2$          NSS$_1$   NSS$_2$    NSS$_3$   NSS$_4$

⟹

NIT$_1$    NIT$_2$         NIT$_3$    NIT$_4$

NC$_1$    NC$_2$    NC$_3$

NC$_1$    NC$_2$    NC$_3$

<u>FIG.4</u>

## FIG.6

## FIG.5

H

N . p

M . p

} p

## FIG.7

H

80

Diagonalisation

MTC

G

81

Multiplication

K

MENC

N Symboles
encodés

## FIG.8

**FIG.9**

## FIG.10

FIG.11

**FIG.12**

130

131

Reception
jeu de N symboles
encodés subdivisés

Décodage

Mise à jour
NSS — 1310

1er sous traitement
NIT — 1311

MM2

Mise à jour
NC — 1312

2ème sous traitement
NIT — 1313

Jeu de K symboles
décodés

# FIG.13

Informations reçues du
canal (LLRs)

$GF(2^{p/n_s})$

$SS_0$   $SS_1$   $SS_2$ ---- $SS_{ns-1}$

$\begin{bmatrix} 2^{p/n_s} \end{bmatrix}$                    $\begin{bmatrix} 2^{p/n_s} \end{bmatrix}$

$NIT_1$                    $NIT_2$

$\begin{bmatrix} 2^p \end{bmatrix}$                    $\begin{bmatrix} 2^p \end{bmatrix}$

$NC_1$                    $NC_2$

FIG.14

131

it=0

i=1

$NC_i$

1315

MM2 — Détermination du
voisinage de $NC_i$

$NSS_j, NIT_k$

1316

Mise à jour
$NSS_j$

1317

1$^{er}$ sous-traitement
$NIT_k$

1318

Mise à jour
$NC_i$

1319

Marginalisation
$NIT_k$

1320

i=M
?

Non → i=i+1 — 1321

oui

1322 — it=it$_{max}$

oui

Non

1323 — it=it+1

Fin

## FIG.15

Code régulier ($d_v$=2, $d_c$=4) Taux = 0,5, $N_b$=864

FIG.16

Code régulier (dv=2, dc=4) Taux = 0,5, Nb=3000 bits

## FIG.17

**RÉFÉRENCES CITÉES DANS LA DESCRIPTION**

*Cette liste de références citées par le demandeur vise uniquement à aider le lecteur et ne fait pas partie du document de brevet européen. Même si le plus grand soin a été accordé à sa conception, des erreurs ou des omissions ne peuvent être exclues et l'OEB décline toute responsabilité à cet égard.*

**Littérature non-brevet citée dans la description**

- Decoding Algorithmes for Nonbinary LDPC Codes over GF (q). *IEEE Trans. On Commun.,* Avril 2007, vol. 55 (4), 633-643